# EUROPEAN PATENT SPECIFICATION

(11) **EP 4 345 922 B1**
(45) Date of publication and mention of the grant of the patent: **07.05.2025**
(21) Application number: 22199219.1
(22) Date of filing: 30.09.2022
(51) Int. Cl.: H01L 33/00, H01L 33/12, H01L 33/32, H01L 21/02

(54) **GAN-ON-SI EPIWAFER COMPRISING A STRAIN-DECOUPLING SUB-STACK**
GAN-AUF-SI-EPIWAFER MIT EINEM SPANNUNGSENTKOPPLUNGS-SUBSTAPEL
PLAQUETTE EPI GAN-SUR-SI COMPRENANT UNE SOUS-PILE DE DÉCOUPLAGE DE CONTRAINTE

(43) Date of publication of application: 03.04.2024
(73) Proprietor: ALLOS Semiconductors GmbH, 01237 Dresden (DE)
(72) Inventor: Nishikawa, Atsushi, 01069 Dresden (DE); Lösing, Alexander, 48691 Vreden (DE)
(74) Representative: Eisenführ Speiser

(56) References cited:
- EP-A1- 3 751 023
- US-A1- 2011 121 357
- US-A1- 2012 003 821
- US-A1- 2012 126 201
- US-A1- 2013 001 644
- US-A1- 2014 353 677

## Description

### FIELD OF THE INVENTION

The invention relates to a GaN-on-Si epiwafer, in particular a GaN-on-Si epiwafer suited for use in III-V nitride based micro light-emitting-diode (LED) technology and/or III-V nitride-based power electronics. Moreover, the invention relates to a method of fabricating a GaN-on-Si epiwafer. The invention further relates to a micro LED structure, e.g., for use in a display.

### BACKGROUND OF THE INVENTION

III-V nitride compound semiconductors such as GaN, InN, AIN are of interest for use in various electronic and optoelectronic applications. For fabricating III-V nitride electronic and optoelectronic devices for commercial applications, active III-V nitride layers with high crystal quality are often required. At the same time, the semiconductor industry strives for high economic efficiency in terms of high numbers of dies per wafer at high yield. To achieve this, a high uniformity of device performance features is generally required. For instance, III-V nitride micro LED devices fabricated from a large epiwafer shall have a high uniformity of emission wavelength to achieve high yield.

Much development effort has therefore been invested into achieving the growth of high crystal quality III-V nitride layers on large-diameter industry-standard silicon wafers. This is to integrate the superior electronic and optoelectronic functionalities of III-V nitride materials into the well-established Si-processing techniques, e.g., in complementary metal-oxide semiconductor (CMOS) or bipolar CMOS (BiCMOS) production lines.

In WO 2007/096405 A1, a nitride semiconductor component is disclosed that comprises a substrate with a silicon surface, an aluminium-containing nitride nucleation layer on the silicon surface of the substrate, an aluminium-containing nitride buffer layer on the aluminium-containing nitride nucleation layer, a masking layer of silicon nitride on the aluminium-containing nitride buffer layer, and a gallium-containing first nitride semiconductor layer on the masking layer of silicon nitride. The gallium-containing first nitride semiconductor layer has a structure of coalesced crystallite growth islands. Layer planes above the distance of at least 600 nm from the masking layer of silicon nitride exhibit an average surface area per crystallite growth island of at least 0.16 µm². Adjoining the gallium-containing first nitride semiconductor layer is a layer sequence formed by an aluminium-containing nitride intermediate layer that has a thickness range of 8 nm to 15 nm, and a gallium-containing second nitride semiconductor layer on the aluminium-containing nitride intermediate layer.

US 2012/003821 A1, EP 3751023 A1, and US 2013/001644 A1 disclose methods of fabricating GaN-based epitaxial layers on a silicon substrate.

### SUMMARY OF THE INVENTION

The invention arises from the objective of providing a GaN-on-Si epiwafer suited for high efficiency industry scale production of optoelectronic or electronic devices based on III-V nitride materials. The invention further arises from the objective of providing a method of fabricating such a GaN-on-Si epiwafer.

According to the invention, a GaN-on-Si epiwafer as defined by claim 1 and a method of fabricating a GaN-on-Si epiwafer as defined by claim 11 is provided. The GaN-on-Si epiwafer forms a layer stack comprising along a stacking direction of the GaN-on-Si epiwafer: a substrate, a strain-decoupling sub-stack and a strain-engineering sub-stack. The substrate has a lateral extension of 150 mm or more, preferably, 150 mm to 450 mm in at least one direction that is perpendicular to the stacking direction, in particular of either 150 mm, 200 mm, or 300 mm, and having a substrate surface facing along the stacking direction that is at least partly formed by silicon. The strain-decoupling sub-stack comprises a self-organized template layer arranged directly on the substrate, the self-organized template layer comprising pits, said pits having a pit density of 1x10⁷ cm⁻² to 1x10¹¹ cm⁻², preferably, of 1x10⁸ cm⁻² to 1x10¹⁰ cm⁻² or of 1x10⁸ cm⁻² to 3x10⁹cm⁻², in particular, of 1x10⁹ cm⁻² to 3x10⁹cm⁻², and a surface recovery layer arranged directly on the self-organized template layer and comprising GaN, the surface recovery layer having a smooth surface pointing along the stacking direction. The strain-engineering sub-stack is arranged on the surface recovery layer and comprising at least one GaN layer and at least one AlₓGa₁₋ₓN intermediate layer, with x ≥ 0.5, the GaN layer having a thickness of 0.5 µm to 4.0 µm, preferably of 0.5 µm to 2.0 µm, the AlₓGa₁₋ₓN intermediate layer having a thickness of 5 nm to 25 nm, preferably, of 10 nm to 15 nm.

A characteristic feature of the proposed GaN-on-Si epiwafer according to the invention is a bow of at most 100 µm, preferably, of at most 50 µm, at room temperature.

The invention acknowledges that there is a steadily increasing demand for GaN-on-Si epiwafers that have a large diameter of more than 150 mm allowing achieving economic manufacturing and a high device yield in absolute and relative numbers. The invention includes the recognition that to achieve high manufacturing efficiency both, a high uniformity and a very small bow of the epiwafer at room temperature are required. A high uniformity is required to be able to fabricate a large number of efficient electronic and optoelectronic devices from the epiwafer that have uniform electronic and optoelectronic characteristics. A very small bow of the epiwafer at room temperature is required to be able to apply standard processing techniques on the epiwafer to fabricate electronic and optoelectronic devices on the epiwafer.

The invention includes the further recognition that due to the lattice mismatch between a Si crystal lattice and a III-V nitride crystal lattice, efficient strain-engineering needs to be accomplished in order to epitaxially grow a III-V nitride layer with high crystal quality, excellent uniformity and low bow on a substrate containing Si. In particular, it would be beneficial to grow a III-V nitride layer on a substantially strain-free surface to obtain high crystal quality III-V nitride layer applied on a substrate containing Si. "Substantially strain-free" herein means that there is substantially no compressive or tensile strain in the respective layer. Growing a III-V nitride layer on such a strain-free surface has the advantage that no strain is induced by the base material to the III-V nitride layer that would result in comparatively poorer crystal quality of the III-V nitride layer. Yet, poorer crystal quality generally means a decrease in electronic and optoelectronic performance.

With the GaN-on-Si epiwafer according to the invention, it is possible to epitaxially grow a high crystal quality III-V nitride layer on a large-diameter substrate containing Si having a diameter of more than 150 mm. With the GaN-on-Si epiwafer this is achieved due to a particular interplay of the layers of the GaN-on-Si epiwafer resulting in a controlled strain evolution within the layer stack. In particular, the controlled strain evolution within the layer stack of the GaN-on-Si epiwafer enables arranging a high crystal quality III-V nitride layer on a substantially strain-free and smooth surface.

The afore-mentioned interplay includes an efficient decoupling of strain that would otherwise arise from a lattice mismatch between the Si-containing substrate and the III-V nitride layers applied above the substrate. In particular, strain decoupling is achieved by the unusual structure of the strain-decoupling sub-stack comprising the self-organized template layer arranged directly on the substrate and the surface recovery layer arranged directly on the self-organized template layer.

A characteristic feature of the strain-decoupling sub-stack is that its self-organized template layer has a comparatively high pit density of 1x10⁷ cm⁻² to 1x10¹¹ cm⁻² of pits distributed over the surface of the self-organized template layer that faces along the stacking direction, i.e. towards the surface recovery layer. While the self-organized template layer, based on the comparatively high pit density, may seem to have a comparatively poor crystal quality, with its rather high pit density it forms a self-organized template for the growth of further layers to be grown on top of the self-organized template layer. During fabrication of the self-organized template layer, the pits form in a self-organized manner, since the positions at which they form is not predefined, e.g., by a mask. Instead, during fabrication of the self-organized template layer, the pits form at random positions that are favoured by the growth conditions. In other words, the pits of the self-organized template layer form in a self-organized manner without any structural processing of the self-organized template layer. Despite the self-organized template layer having a high pit density and thus poor crystal quality, the self-organized template layer preferably is a crystalline layer with a predominant crystal structure, e.g., Wurtzite, preferably, Wurtzite AIN.

It is the comparatively high pit density in the self-organized template layer that contributes to an efficient relief of strain in the surface recovery layer resulting from a lattice mismatch between the material of the self-organized template layer and the material of the substrate. In turn, the efficient relief of strain in the surface recovery layer contributes to preventing strain to propagate into the strain-engineering sub-stack and to provide a substantially strain-free and smooth surface for the further growth of the strain-engineering sub-stack and of additional layers on top of the strain-engineering sub-stack, such as an active layer structure as described in more detail further below.

In particular, due to growing the surface recovery layer on the self-organized template layer with having pits distributed over its surface, the surface recovery layer can be fabricated to be substantially strain-free. This is achieved since the pits enable an initial pyramidal growth of the surface recovery layer in which pyramidal structures form between the pits on the surface of the self-organized template layer. The pyramidal structures increase in their volume on their pyramidal-shaped side facets. Thereby, the pyramidal structures grow over the pits to form the surface recovery layer. Herein, this initial growth of pyramidal structures is referred to as a "pyramidal growth mode". The pyramidal growth mode has the particular advantage that dislocations bend towards pyramidal-shaped side facets and stop propagating or stop propagating along the stacking direction, resulting in a both a high crystal quality and strain-free surface recovery layer.

The surface recovery layer also has a substantially smooth surface facing along the stacking direction. The substantially smooth surface of the surface recovery layer is particularly achieved by changing from the pyramidal growth mode to a growth mode that is referred to herein as a "layer-by-layer growth mode". In the layer-by-layer growth mode surface recovery layer grows epitaxially along the stacking direction with a significantly reduced dislocation density. Thereby, the surface recovery layer provides a substantially smooth surface for the growth of the strain-engineering sub-stack. At its smooth surface, the surface recovery layer has a comparatively high crystal quality with a reduced dislocation density, e.g., in comparison to the opposite surface forming the interface between the self-organized template layer and the surface recovery layer. The strain-engineering sub-stack can thus be grown on a substantially strain-free basis and on a substantially smooth surface with high crystal quality.

When growing the surface recovery layer onto the self-organized template layer, the material of the surface recovery layer may not fill the pits but only cover them. Alternatively, when growing the surface recovery layer onto the self-organized template layer, the material of the surface recovery layer may at least partly fill the pits and also cover them. After having grown the surface recovery layer onto the self-organized template layer, the pits may be thus either be at least partly filled with material of the surface recovery layer or they may be not filled with material of the surface recovery layer.

Furthermore, since the strain-engineering sub-stack is arranged on a substantially smooth and strain-free basis a particularly precise strain-engineering with high uniformity is possible in the strain-engineering sub-stack. It is thus the presence of the self-organized template layer and the surface recovery layer, which further promotes the ability of an accurate strain-engineering with the AlₓGa₁₋ₓN intermediate layer in the strain-engineering sub-stack. With the AlₓGa₁₋ₓN intermediate layer it may be possible to compensate tensile strain with a compressive strain component to the GaN. Due to accurate and precisely controlled strain-engineering, thick layer stacks and high crystal quality GaN can be achieved.

It is a further advantage of the decoupling of the strain-engineering sub-stack from strain that would otherwise be induced by the substrate that the curvature of the GaN-on-Si epiwafer during its fabrication can additionally be made easier and more precisely. The precise control of the curvature of the GaN-on-Si epiwafer during its fabrication enables achieving a particularly low bow of the GaN-on-Si epiwafer of at most 100 µm at room temperature and - if an active layer structure is added to the GaN-on-Si epiwafer - an excellent emission wavelength uniformity at the same time. An excellent emission wavelength uniformity of an active layer structure can be achieved since by controlling the curvature of the GaN-on-Si epiwafer during its fabrication allows to establish a uniform distribution of the surface temperature of the GaN-on-Si epiwafer during fabrication while applying the active layer structure on the GaN-on-Si epiwafer. A uniform temperature distribution of the GaN-on-Si epiwafer is beneficial for growing active layer structure with a uniform material distribution that in turn is beneficial for excellent emission wavelength uniformity. For example, if the active layer structure comprises an InGaN quantum well, a uniform temperature distribution of the GaN-on-Si epiwafer favours a homogeneous distribution of indium in the InGaN quantum well.

As a result of the afore-described interplay of the layers of the GaN-on-Si epiwafer, the GaN-on-Si epiwafer thus provides a commercially attractive technology basis for various applications in micro LED technology and high power electronics. Herein, an "epiwafer" comprises a substrate and one or more layers that are epitaxially grown on said substrate.

The substrate itself does not necessarily have to be fabricated using epitaxy. Herein, the terms "wafer" and "substrate" are used synonymously in that they refer to a semiconductor body with a surface usable for growing an epitaxial layer on top of it. While any suitable substrate as described in various sections of this specification may be used, the method of the invention is particularly suited for fabricating GaN-on-Si epiwafers on silicon wafers with a diameter of 150 mm or more which are used in the semiconductor industry. Such wafers typically have a round shape with one or more flat cut edge portions or notches for indicating the surface orientation and doping, and for alignment of the wafer during manufacturing.

In the GaN-on-Si epiwafer, the pits thus extend from the interface between the self-organized template layer and the surface recovery layer into the self-organized template layer. An individual pits forms a recess in the surface of the self-organized template layer. The pits may have a depth of at least 7 nm and can extend up to 50 nm or even further into the self-organized template layer. A fraction of pits of the self-organized template layer may be allowed to fully penetrate the self-organized template layer along its thickness, i.e., from the interface between the self-organized template layer and the surface recovery layer down to the interface between the self-organized template layer and the substrate. However, this may occur as a consequence of growth parameter settings in a given individual reactor and does not form an essential feature of the invention. The claimed method may comprise fabricating a self-organized template layer that has only pits which do not fully penetrate the self-organized template layer down to the substrate.

"Pit density" refers to the density of pits distributed over a surface or (in particular when assessing the density from a cross sectional image after growth) interface, e.g., of the self-organized template layer. It is defined by the number of pits present within a predefined surface unit area.

"Bow" is a deviation of the centre point of a median surface of a free, un-clamped wafer from a reference plane, where the reference plane is defined by three corners of an equilateral triangle. A "bow" of a wafer can be measured according to the "Test Method for Bow of Silicon Wafers" as defined in the standard ASTM F534-97.

"Room temperature" refers to a temperature in an everyday environment and typically ranges between 20 °C and 30 °C.

A smoothness of the smooth surface of the surface recovery layer may be comparable to a smoothness of the substrate surface of the substrate. A smooth surface as used in this specification is characterised by a reflectivity of 35 % to 50 %, preferably, of 40 % to 45 %. The reflectivity may for example be measured using an in-situ monitoring method, e.g., during MOCVD growth. The reflectivity may particularly refer to a ratio of reflected and impinging light. Additionally or alternatively, a smooth surface as used in this specification is characterised by a surface roughness (e.g., root mean square roughness) of 1 nm or less, e.g., 0.5 nm or less.

A Si-containing substrate may be a substrate that is fully comprised of Si. Alternatively, a Si-containing substrate may be a substrate that at least at its substrate surface facing along the stacking direction has the crystal structure of Si and/or the bulk lattice parameter of Si. For example, a Si-containing substrate may be a SiON substrate or an engineered substrate with a Si(111) substrate surface. Yet, alternatively, a Si-containing substrate may be a silicon-on-insulator (SOI) substrate.

In the following, preferred embodiments of the GaN-on-Si epiwafer of the invention will be described.

Advantageously, due to the strain-decoupling of the strain-engineering sub-stack from the substrate, the strain-engineering sub-stack's AlₓGa₁₋ₓN intermediate layer allows a reproducible strain-engineering in the strain-engineering sub-stack during fabrication of the GaN-on-Si epiwafer. To achieve a low bow of the GaN-on-Si epiwafer at room temperature, the Aluminium content in the AlₓGa₁₋ₓN intermediate layer is preferably equal or larger than 50 %. Preferably, the thickness of the AlₓGa₁₋ₓN intermediate layer is between 5 nm and 25 nm.

The substrate may have a thickness of at least 1 millimetre, preferably, of 1.2 mm to 1.6 mm. By using a comparatively thick substrate, in particular, a Si-containing substrate, plastic deformation of the Si-containing substrate when growing thick nitride layer stacks can be prevented and therefore a good crystal quality of the GaN in the strain-engineering sub-stack can be achieved.

The comparatively thick GaN-on-Si epiwafer may for instance be thinned from a backside of the substrate to SEMI-standard thickness for further use and acceptance by standard semiconductor processing lines. "SEMI-standard thickness" is defined in accordance with a standard wafer diameter such that for a 150 mm wafer, the SEMI-standard thickness is 675 +/-20 µm or 625 +/- 15 µm, for a 200 mm wafer, the SEMI-standard thickness is 725 +/-20 µm and for a 300 mm wafer, the SEMI-standard thickness is 775 +/-20 µm.

Preferably, the GaN-on-Si epiwafer further comprises an active layer structure arranged on the strain-engineering sub-stack. The active layer structure preferably comprises a multi-quantum-well structure of III-V nitride materials such as InGaN and GaN, which is configured to emit light under application of an operating voltage or under optical excitation. Additionally or alternatively, the active layer structure may comprise a lasing structure configured for emitting laser radiation. Additionally or alternatively, the active layer structure may comprise a transistor structure. The transistor structure may be a high electron mobility transistor (HEMT) structure. The transistor structure may be a vertical transistor structure, e.g., a vertical HEMT structure, with its layers being stacked along the stacking direction of the GaN-on-Si epiwafer. Alternatively, the transistor structure may be a horizontal transistor structure, e.g., a horizontal HEMT structure, with its layers being arranged laterally, parallel to the stacking direction of the GaN-on-Si epiwafer. The GaN-on-Si epiwafer having the active layer structure may be used for fabricating micro LEDs. The multi-quantum-well structure of III-V nitride materials may comprise a p-doped III-V nitride material layer and an n-doped III-V nitride material layer and an active area comprising several quantum wells thereby implementing a p-n junction. When applying an operating voltage, electrons and holes recombine resulting in an emission of photons.

In particular, the GaN-on-Si epiwafer having the active layer structure may be configured such a way that under application of an operating voltage or under optical excitation, e.g., by UV laser, the multi-quantum-well structure exhibits an emission wavelength uniformity of +/- 3 nm or less, or of +/- 1 nm or less. An emission wavelength uniformity of +/- 3 nm or less, or of +/- 1 nm or less can be achieved by a precise control of the curvature of the GaN-on-Si epiwafer while growing the active layer structure to establish a uniform heat distribution on the surface of the GaN-on-Si epiwafer.

In addition, due to the strain-decoupling caused by the strain-decoupling sub-stack, the GaN in the strain-engineering sub-stack of the GaN-on-Si epiwafer may have a comparatively high crystal quality. Moreover, due to the efficient strain-decoupling, the GaN-on-Si epiwafer has a flat bow of at most 100 µm at room temperature also after thinning of the GaN-on-Si epiwafer. Furthermore the strain-decoupling and strain-engineering are contributing to achieving an emission wavelength uniformity of +/- 3 nm or less, or of +/- 1 nm despite of the trade-off between epiwafer flatness and high emission uniformity. The wavelength uniformity of +/- 3 nm or less, or of +/- 1 nm or less refers to an emission of light from at least 80 % or even at least 90% of the active layer structure of the GaN-on-Si epiwafer. Based on the GaN-on-Si epiwafer having the active layer structure, micro LEDs may be fabricated with high yield, e.g., for use in display technology.

It is thus a particular advantage of the GaN-on-Si epiwafer that even after thinning, the GaN-on-Si epiwafer has a bow of at most 100 µm, e.g. of less than 50 µm, at room temperature. Due to the high quality of the GaN of the strain-engineering sub-stack and a bow of at most 100 µm also after thinning of the GaN-on-Si epiwafer, highly efficient micro LEDs or high electron mobility transistors (HEMT) can be fabricated using the GaN-on-Si epiwafer. Micro LEDs fabricated from the GaN-on-Si epiwafer may have a comparatively high external quantum efficiency (EQE) and a uniform emission wavelength, e.g., in the range of +/- 1 nm.

Preferably, the self-organized template layer has a thickness of 50 nm to 300 nm, preferably, of 100 nm to 200 nm. A thickness of 50 nm to 300 nm may ensure a sufficient decoupling of the strain between the Si-containing substrate and the strain-engineering sub-stack such that the GaN in the strain-engineering sub-stack may have comparatively high crystal quality. Herein, the term "high crystal quality" refers to a dislocation density of 5x10⁸ cm⁻² or less. A self-organized template layer having a thickness of 50 nm to 300 nm can be fabricated with a pit density of 1x10⁷ cm⁻² to 1x10¹¹ cm⁻² at a template surface that points in the stacking direction. In particular, a self-organized template layer having a thickness of 50 nm to 300 nm is expected to suffer less from an insufficient pit formation, e.g., in terms of pit density and/or pit size. Preferably, the self-organized template layer is an Al-containing nitride layer, even more preferably an AlN-layer. Yet, it is possible that the self-organized template layer being an Al-containing nitride layer comprises further elements next to Al, e.g., further group-III elements such as Ga. AIN is preferred since its columnar growth mode provides a sufficient strain-decoupling between the substrate and the strain-engineering sub-stack. Another advantage provided by the self-organized template layer being an AlN-layer is the prevention of meltback etching, i.e. a deteriorating chemical reaction occurring between Ga and the Si of the substrate. Yet, if meltback etching may be acceptable to a certain degree, the self-organized template layer may also be an AlGaN-layer.

Preferably, the pits in the self-organized template layer have a pit size of 1 nm to 100 nm, preferably, of 10 nm to 50 nm, in particular of 10 nm to 30 nm. The pit size refers to a lateral extension of the pits perpendicular to the stacking direction, e.g., of an opening at the template surface of the self-organized template layer that faces away from the substrate. A pit size of 1 nm to 100 nm is preferred for providing a self-organized template comprising pits that can be overgrown in a pyramidal growth mode.

The pits of the self-organized template layer may be created, e.g., due to columnar growth of the material of the self-organized template layer, e.g., AIN. The columnar growth of the self-organized template layer can be controlled by adjusting the growth conditions applied during growth of the self-organized template layer. Columnar growth of the self-organized template layer was found to work particular well, if the self-organized template layer is an Al-containing nitride layer, and in particular an AlN-layer. This is because of the comparatively low surface migration of Al atoms, e.g., in comparison to Ga atoms. It is thus particularly the presence of Al atoms in the self-organized template layer that promotes a columnar growth of the self-organized template layer and a formation of pits with a pit density of 1x10⁷ cm⁻² to 1x10¹¹ cm⁻². The columnar growth is self-organized without the involvement of any structuring, e.g., masking, such that also the pits form self-organized during the columnar growth.

Preferably, the pits of the self-organized template layer have an average pit distance between adjacent pits that is in the range of 200 nm to 2000 nm, preferably, of 200 nm and 1000 nm, e.g., of 200 nm, 500 nm, 1000 nm or 2000 nm. In particular, the pit distance between adjacent pits may be determined by measuring the distance from the centre of one pit to the centre of a directly adjacent neighbouring pit. The average pit distance between adjacent pits may be calculated by determining the individual distances between neighbouring pits and then taking the average of the collected distances. An average pit distance between adjacent pits that is in the range of 200 nm to 2000 nm is preferred since it provides a self-organized template layer on which the pits can be overgrown by the epitaxially grown surface recovery layer.

During fabrication of the GaN-on-Si epiwafer, the pit density of the self-organized template layer may be controlled as described in the following.

Sometimes, a substrate having a Si-containing substrate surface facing along the stacking direction is covered by a native oxide. Generally, a formation of a native oxide on a Si-containing substrate surface saturates after a certain amount of time resulting in a uniform thickness. If a Si-containing substrate surface is covered with a native oxide, initially, and if necessary, the Si-containing substrate surface may be prepared by conducting the following steps:
- providing a substrate having a Si-containing substrate surface facing in the stacking direction and having a diameter of 150 mm or more, preferably, of 150 mm to 450 mm, said substrate surface being covered by a native oxide, and
- adapting at least one growth parameter for at least partly removing the native oxide.

Growth parameters that may be adapted for removing the native oxide may be a substrate temperature, a reactor pressure, and/or a reactor atmosphere. In addition, the time span over which the growth parameters are adapted for removal of the native oxide may be selected. For example, the substrate temperature, the reactor pressure, and/or the atmosphere may be tuned into a regime where the native oxide covering the Si-containing substrate surface is at least partly removed.

During oxide removal, the substrate will exhibit a concave bow due to the temperature difference between the substrate's back and front surface, wherein the front surface is the substrate surface used for growing subsequent layer on the substrate. Therefore, more careful parameter tuning may in general be required to achieve a uniform temperature distribution on the front surface of the substrate especially with the substrate showing a concave bow during the oxide removal.

The time and reactor condition over which oxide removal is carried out, preferably, is selected such that the native oxide is removed to a large extend. This can comprise that the native oxide is fully removed. However, the native oxide may also only be partly removed such that some parts of the prior covered surface are still covered by the native oxide and other parts of the prior covered surface are not covered by the native oxide anymore. Removing the native oxide only partly may be of advantage since thereby it can be avoided that the time for oxide removal is selected too long such that the Si-containing substrate surface becomes rough due to etching into the substrate surface after oxide removal. Having the surface of the Si-containing substrate partly covered with a native oxide, i.e., after an incomplete oxide removal, may also be beneficial for the formation of pits in the subsequently grown self-organized template layer.

When having a Si-containing substrate surface with an at least partly removed native oxide, the self-organized template layer may be grown on top of it thereby controlling the formation of pits, e.g., in the following way:
- optionally, providing a wafer carrier for holding a wafer, the wafer carrier comprising a wafer carrier body having at least one carrier pocket for accommodating a wafer, the carrier pocket having a bottom surface, and a support surface located at a predefined vertical distance from the bottom surface, the support surface being configured for supporting the wafer, wherein the bottom surface has a convex shape or comprises a convex-shaped bottom surface section, which is curved upwards when seen in a cross-sectional view,
- providing a substrate having a Si-containing substrate surface facing in the stacking direction and having a diameter of 150 mm or more, preferably, of 150 mm to 450 mm, optionally, on the support surface of the wafer carrier's carrier pocket, said substrate surface being free of a native oxide or being only partly covered by a native oxide, and
- adapting at least one growth parameter for growing the self-organized template layer.

As mentioned before, the self-organized template layer, preferably, comprises a first sub-layer that is an Al-containing layer, e.g., an Al-layer. Thus, for growing the self-organized template layer, a gas containing the constituents of the self-organized template layer is introduced via a gas inlet into a reaction chamber. Growth parameters that may be adapted for the growth of the self-organized template layer may be a substrate temperature, a reactor pressure and a reactor gas flow. In particular, the growth parameters such as substrate temperature, reactor pressure etc. may be tuned into a regime where pits form in the self-organized template layer. Preferably, the self-organized template layer is grown up to a thickness of 50 nm to 300 nm, e.g., between 100 nm and 200 nm. A layer thickness below 50 nm may be used.

By choosing the growth parameters accordingly, the self-organized template layer can be grown in a columnar mode, which may comprise that there are parts on the substrate surface where nucleation of the self-organized template layer is prevented. Parts of the substrate surface where nucleation of the self-organized template layer is prevented may comprise a rest of the oxide layer and/or crystal defects or other defects. The columnar growth is particularly efficient when using AIN for the self-organized template layer. The invention includes the further recognition that a comparatively high substrate temperature is beneficial for the formation of pits as part of the crystalline self-organized template layer. In addition, comparatively high substrate temperature is preferred since the self-organized template layer can be grown as a crystalline layer. In contrast, in the prior art it is generally tried to grow low-temperature AIN on a Si-containing substrate.

The invention includes the further recognition that the pits can be used to form a self-organized template for a layer that is grown on the self-organized template layer, e.g., the surface recovery layer. In the self-organized template layer, it is possible that one or more pits extend from the template surface down through the full self-organized template layer to the substrate surface of the substrate. The template surface of the self-organized template layer thus implements a template similar to a mask where the holes of that mask can be overgrown. Thereby, the pits are covered by overgrowth of the subsequent layer. Due to the pyramidal growth mode, the subsequent surface recovery layer can be grown substantially strain-free, i.e., having no compressive or no tensile strain. Because the subsequent layer can be grown substantially strain-free, a decoupling of strain between the substrate and the strain-engineering sub-stack can be achieved. It is thus preferred in the GaN-on-Si epiwafer to have a comparatively large number of pits, i.e., a comparatively high pit density, in the self-organized template layer in order to provide a self-organized template. Having the self-organized template layer with a comparatively large number of pits thus makes an additional masking layer as used in the prior art obsolete.

Advantageously, by means of growing the surface recovery layer on the self-organized template layer results in an efficient decoupling of the strain between the substrate and the strain-engineering sub-stack following the surface recovery layer along the stacking direction. The approach described herein contradicts what is generally aimed for in the prior art that is to improve the crystal quality in the self-organized template layer, e.g., an Al-containing layer, to achieve subsequent III-V nitride layers with high crystal quality.

Preferably, in addition to a comparatively high pit density, the GaN-on-Si epiwafer's self-organized template layer has a total dislocation density of 10⁹ cm⁻² or more throughout a thickness of the self-organized template layer along the stacking direction. The total dislocation density is defined as the amount of all line defects at a certain interface in a crystalline solid-state body. In the GaN-on-Si epiwafer's self-organized template layer, the total dislocation density is 10⁹ cm⁻² or more throughout the entire thickness of the self-organized template layer, i.e., the self-organized template layer has a total dislocation density of 10⁹ cm⁻² or more within its entire volume. Preferably, the self-organized template layer has a total dislocation density of 10⁹ cm⁻² to 10¹¹ cm⁻². The comparatively high total dislocation density in the self-organized template layer contributes to a decoupling of strain between the strain-engineering sub-stack and the substrate. As a result, an at least partial decoupling in terms of strain of the Si-containing substrate and the further layers of the GaN-on-Si epiwafer, and in particular the GaN of the strain-engineering sub-stack, can be achieved. Moreover, some dislocations present in the self-organized template layer may continue into the surface recovery layer. In the surface recovery layer these dislocations may bend due to the formation of pyramidal structures when growing the surface recovery layer and/or may annihilate. Thereby, these dislocations are prevented from propagating up to the smooth surface of the surface recovery layer that forms the basis for the fabrication of the strain-engineering sub-stack.

Having a self-organized template layer with comparatively poor crystal quality, i.e., high total dislocation density and preferably also high pit density, stands in contrast to what is generally aimed for in the prior art when it comes to fabricating a GaN-on-Si epiwafer. According to the prior art one would try to grow the self-organized template layer with the best crystal quality possible. Having a self-organized template layer with comparatively poor crystal quality as present in the GaN-on-Si epiwafer described herein therefore constitutes a change of paradigm.

Preferably, the self-organized template layer comprises line defects of which at least 50 %, or at least 70 % or at least 90 %, have an angle with respect to the stacking direction of 0° to 20°, preferably, of substantially 0°, or in the range of 0° to 2°. Having line defects that run substantially in the same direction as the stacking direction allows efficient strain relief and thus strain decoupling of the substrate and the strain-engineering sub-stack. Efficient strain relief is in particular achieved since the dislocations running substantially parallel to the stacking direction evolve into the surface recovery layer. In the surface recovery layer these dislocations bend and/or annihilate such that the dislocation density in the surface recovery layer decreases along the stacking direction. It is particularly preferred that the surface recovery layer comprises dislocations that bend under an angle of 15° to 45° with respect to an interface formed between the self-organized template layer and the surface recovery layer. In the self-organized template layer, it is thus considered beneficial if the line defects run along the stacking direction, which is in contrast to what is generally aimed for, namely, an improvement of the crystal quality in a corresponding layer of a state-of-the-art GaN-on-Si epiwafer.

The strain-engineering sub-stack may comprise only a single GaN layer and a single AlₓGa₁₋ₓN intermediate layer and may start either with GaN layer or with the AlₓGa₁₋ₓN intermediate layer. However, it may be beneficial if the strain-engineering sub-stack comprises at least two repetitions of a sequence of the GaN layer and the AlₓGa₁₋ₓN intermediate layer or of the AlₓGa₁₋ₓN intermediate layer and the GaN layer, with x ≥ 0.5. By increasing the numbers of repetitions, the strain in the strain-engineering sub-stack can be more accurately and individually controlled. For example, each of the AlₓGa₁₋ₓN intermediate layers present in the strain-engineering sub-stack may have a different thickness and/or Al content to ensure an efficient strain balancing in the GaN-layers of the strain-engineering sub-stack. This allows further improving the crystal quality of the GaN-layers of the strain-engineering sub-stack. In addition, it can be expected that the crystal quality further improves with each repetition. This allows continuing the growth until a GaN-layer of the strain-engineering sub-stack has sufficient crystal quality for a certain application. It is also possible to grow additional repetitions until the crystal quality of the GaN-layer of the respective repetitions does not change anymore. The GaN-on-Si epiwafer may then be thinned from the backside for further use up to the GaN-layer of the GaN-on-Si epiwafer that exhibits the required crystal quality.

Preferably, the self-organized template layer comprises a first sub-layer that is an AIN layer and a second sub-layer comprising AlₓGa₁₋ₓN, with 0 < x < 1, that is arranged directly on top of the first-sub-layer. In particular, the self-organized template layer may comprise a second sub-layer that is a Ga-containing nitride layer. However, the second sub-layer may also be an AIN, a GaN or an AlGaN layer. With the second sub-layer, it is possible to achieve a further improved decoupling between the substrate and the strain-engineering sub-stack. In particular, with the second sub-layer, it is possible to fine-tune the size and density of the pits that are generated in the self-organized template layer. Thereby, the uniformity of the pits can be improved. In turn, this allows providing an improved template surface for the growth of the surface recovery layer.

Accordingly, if present, the second sub-layer also exhibits a pit density of 1x10⁷ cm⁻² to 1x10¹¹ cm⁻², preferably, of 1x10⁸ cm⁻² to 1x10¹⁰cm⁻2 or of 1x10⁸ cm⁻² to 3x10⁹cm⁻², in particular, of 1x10⁹ cm⁻² to 3x10⁹cm⁻², and/or an average pit distance between adjacent pits that is in the range of 200 nm to 2000 nm, preferably, of 200 nm and 1000 nm, e.g., of 200 nm, 500 nm, 1000 nm or 2000 nm, and/or a pit size of 1 nm to 100 nm, preferably, of 10 nm to 50 nm, in particular of 10 nm to 30 nm. Thus, if present, the second sub-layer thus provides at its surface facing away from the substrate the template surface of the self-organized template layer for the growth of the surface recovery layer. In case, a second sub-layer is present, the second sub-layer is thus grown on the first sub-layer already having pits and the second sub-layer itself provides a template surface for the growth of the surface recovery layer on top of it.

In particular, if the first sub-layer is made of AIN, it may be beneficial, if the second sub-layer is made of AlGaN because the lattice parameter of AlGaN is closer to the GaN of the surface recovery layer. The second sub-layer may thus be considered to implement a bridge from the lattice parameter of AIN of the first sub-layer to the GaN of the surface recovery layer. Thereby, the crystal quality of the surface recovery layer can be improved which in turn may yield an improved smoothness of the smooth surface of the surface recovery layer pointing in the stacking direction.

The second sub-layer may have a total thickness of 50 nm to 150 nm. The surface recovery layer may be made of GaN, only. However, the surface recovery layer may comprise fractions of other group-III metals such as Al or In and may be a ternary or quaternary alloy or the like. Yet, it is preferred if the lattice constants of the surface recovery layer deviates no more than 5 %, e.g. no more than 3 % or no more than 1 % from the lattice constants of bulk GaN that are a= 3.189 Å and c= 5.178 Å at 300 K.

With regard to the above-mentioned objective directed to a method of fabricating a GaN-on-Si epiwafer, a method of fabricating a GaN-on-Si epiwafer is proposed comprising the steps of
- providing a wafer carrier for holding a wafer, the wafer carrier comprising a wafer carrier body having at least one carrier pocket for accommodating a wafer, the carrier pocket having a bottom surface, and a support surface located at a predefined vertical distance from the bottom surface, the support surface being configured for supporting the wafer, wherein the bottom surface has a convex shape or comprises a convex-shaped bottom surface section, which is curved upwards when seen in a cross-sectional view,
- arranging a substrate having a diameter of 150 mm or more, preferably, of 150 mm to 450 mm in at least one direction that is perpendicular to the stacking direction, in particular of either of 150 mm, 200 mm, 300 mm or 450 mm or 500 mm, and having a substrate surface facing along the stacking direction that is at least partly formed by silicon, on the support surface of the wafer carrier's carrier pocket,
- fabricating a strain-decoupling sub-stack by epitaxially growing a self-organized template layer directly on top of the substrate such that the self-organized template layer has pits with a pit density of 1x10⁷ cm⁻² to 1x10¹¹ cm⁻², preferably, of 1x10⁸ cm⁻² to 1x10¹⁰cm⁻² or of 1x10⁸ cm⁻² to 3x10⁹cm⁻², in particular, of 1x10⁹ cm⁻² to 3x10⁹cm⁻², and epitaxially growing surface recovery layer comprising GaN directly on the self-organized template layer, such that surface recovery layer has a substantially smooth surface facing along the stacking direction,
- controlling a curvature of the GaN-on-Si epiwafer by epitaxially growing, using at least a strain-engineering sub-stack on top of the surface recovery layer, the strain-engineering sub-stack comprising at least one GaN layer and at least one AlₓGa₁₋ₓN intermediate layer, with x ≥ 0.5, the GaN layer having a thickness of 0.5 µm to 4.0 µm, preferably, of 0.5 µm to 2.0 µm, the AlₓGa₁₋ₓN intermediate layer having a thickness of 5 nm to 25 nm, preferably, of 10 nm to 15 nm, and
- allowing the GaN-on-Si epiwafer to cool down to an ambient room temperature.

With the method according to the invention, the above-described GaN-on-Si epiwafer according to the invention can be fabricated.

The method according to the invention can be carried out, e.g., using a molecular beam epitaxy (MBE) setup or a metalorganic vapour phase epitaxy (MOVPE) setup or other suitable crystal growth setups, e.g., chemical vapour deposition (CVD) setup.

The predefined vertical distance from the bottom surface to the support surface may be between 0.05 mm and 1 mm, e.g., between 1 mm and 0.25 mm.

The growth of the surface recovery layer may comprise different growth modes that are characterised by different growth parameter values of, e.g., an applied pressure, a gas flow ratio and a growth temperature. These growth modes may comprise the pyramidal growth mode, the layer-by-layer growth mode and a transitional growth mode that results when changing the growth parameters to change from the pyramidal growth mode to the layer-by-layer growth mode. Yet, the transitional growth mode itself may be applied for a predefined time span if desired. However, the transitional growth may be short such that growth of the surface recovery layer substantially only includes the pyramidal growth mode and the layer-by-layer growth mode.

In general, on the self-organized template layer, it is preferred that initially the surface recovery layer is grown in the pyramidal growth mode in which pyramidal structures form on the self-organized template layer's template surface that increase in size due to growth on their side facets. Thereby, the pits are overgrown. In fact, the self-organized template layer including the pits particularly promotes a formation of pyramidal structures in the pyramidal growth mode and a growth on their side facets. The formation of pyramidal-shaped structures may be enhanced by dislocations in the GaN of the surface recovery layer that are propagating along the growth direction. Due to this pyramidal growth, dislocations bend towards the side facets of the pyramidal structures and/or stop propagating along the stacking direction. In fact, in the pyramidal growth mode, dislocations may bend and annihilate when they meet another dislocation present. This enables a formation of a substantially smooth surface of a substantially strain-free surface recovery layer pointing in the stacking direction.

While in the growth of the surface recovery layer pyramidal growth occurs, in the layer-by-layer growth mode the surface recovery layer grows in particular along the stacking direction. Between the pyramidal growth mode and the layer-by-layer growth mode, a transitional growth mode may be applied for a certain time span. In the transitional growth mode, the surface recovery layer grows both, horizontally and along the stacking direction, i.e., there is a horizontal growth component as well as a vertical growth component. In the layer-by-layer growth mode, the surface recovery layer substantially grows along the stacking direction thereby forming the substantially smooth surface of the surface recovery layer. When applying the pyramidal growth mode as well as the layer-by-layer growth mode when fabricating the surface recovery layer, the surface recovery layer may be substantially strain-free. The strain-engineering sub-stack can thus be fabricated onto the surface recovery layer decoupled from strain induced by the substrate.

In the method, the curvature of the GaN-on-Si epiwafer can be controlled, e.g., by adapting the degree of strain decoupling of the strain-engineering sub-stack from the Si-containing substrate by adapting the growth parameters accordingly when growing the self-organized template layer. In the method, it is particularly preferred that the curvature of the GaN-on-Si epiwafer substantially corresponds to the shape of the bottom surface being convex or comprising a convex-shaped bottom surface section. Thereby, it is possible to maintain during growth of the strain-engineering sub-stack and in particular of an active layer structure grown on top of the strain-engineering sub-stack a substantially constant distance between the GaN-on-Si epiwafer and the bottom surface of the carrier pocket. Establishing a substantially constant distance between the GaN-on-Si epiwafer and the bottom surface of the carrier pocket while growing the strain-engineering sub-stack and in particular of an active layer structure is of advantage since they can be grown with substantially uniform growth temperature along the GaN-on-Si epiwafer. In turn, uniform growth temperature may be beneficial to obtain uniform electronic and/or optoelectronic properties of the GaN-on-Si epiwafer.

The curvature of the GaN-on-Si epiwafer can be controlled, e.g., by adapting the amount of Al in the AlₓGa₁₋ₓN intermediate layer and/or the thickness of the AlₓGa₁₋ₓN intermediate layer. Thereby, the amount of compensating tensile strain with a compressive strain component to the GaN can be tuned which in turn has an impact on the curvature of the GaN-on-Si epiwafer. Accordingly, in the method, the curvature of the GaN-on-Si epiwafer is controlled by strain-engineering within the strain-engineering sub-stack. For adjusting the strain, the Al content of an AlₓGa₁₋ₓN intermediate layer or a thickness of an AlₓGa₁₋ₓN intermediate layer or the growth temperature may be adjusted. The Al content or the thickness or the growth temperature can be adjusted by performing in-line process control. The Al content or the thickness or the growth temperature may also be controlled as part of planned adjustment in a programmed process flow before actually growing the AlₓGa₁₋ₓN intermediate layer of the strain-engineering sub-stack.

Accordingly, in the method controlling the curvature of the GaN-on-Si epiwafer may further comprise adjusting a growth parameter, such as the Al content described above, to achieve a convex curvature with a normal (i.e. perpendicular) distance between the bottom surface of the carrier pocket and the GaN-on-Si epiwafer that is substantially constant across the wafer diameter. Preferably, a substantially constant distance between the bottom surface of the carrier pocket and the GaN-on-Si epiwafer is achieved at the growth temperature, in particular, while growing an active layer structure.

As a result of controlling the curvature of the GaN-on-Si epiwafer to have a substantially constant distance to the bottom surface of the carrier pocket the bow of the GaN-on-Si epiwafer during growth in particular of the active layer structure may correspond substantially to the curvature of the bottom surface of the carrier pocket. Thereby, it is possible to establish a uniform temperature distribution between the GaN-on-Si epiwafer and the carrier pocket. This uniform temperature distribution has the advantage of fabricating a crystal layer of the GaN-on-Si epiwafer under uniform growth conditions. Such uniform growth conditions are particularly desired for fabricating the active layer structure that may be sensitive to temperature variations.

In addition, thermal stresses in the GaN-on-Si epiwafer may be reduced that otherwise may be caused by temperature differences within the GaN-on-Si epiwafer. Thereby, an active layer structure may be grown on top of the strain-engineering sub-stack with a comparatively homogenous heat distribution between bottom surface of the carrier pocket and the GaN-on-Si epiwafer. This has the advantage that the active layer structure can be grown comparatively uniform. For example, in case the active layer structure comprises one or more InGaN quantum wells intended for light emission, due to the comparatively homogenous growth conditions in particular in terms of heat distribution, In may be incorporated comparatively uniform within the InGaN quantum wells. In particular, an accordingly grown GaN-on-Si epiwafer is suitable for fabrication a micro LED having an excellent emission wavelength uniformity of +/- 3 nm or less, or +/- 1 nm or less. Preferably, the self-organized template layer is grown to have a first sub-layer that is an Al-containing layer. It is possible that the strain-decoupling layer is only formed by the first sub-layer. However, optionally, the method may comprise a step of epitaxially growing a second sub-layer made of AlₓGa₁₋ₓN, with 0 ≤ x ≤ 1, on top of the first sub-layer before growing the surface recovery layer and the strain-engineering sub-stack on the strain-decoupling layer. The strain-decoupling layer then comprises the first sub-layer and the second sub-layer. With the second sub-layer, an even further improved strain decoupling between substrate and strain-engineering sub-stack may be achieved. With the second sub-layer, it is also possible to provide an improved uniformity of the pits generated by growing the self-organized template layer.

If a second sub-layer is grown as part of the self-organized template layer, in the method it is furthermore preferred that the second sub-layer is grown on an upper surface of the first sub-layer along the stacking direction by using the pits of the first sub-layer as a self-organized template. The second sub-layer itself comprises pits having a similar pit density as for the pits of the first sub-layer. The pits of the second sub-layer may then equally be used as a self-organized template for growing the surface recovery layer on top of the self-organized template layer.

Preferably, in the method, after cooling down to an ambient room temperature, the GaN-on-Si epiwafer has a bow of at most 100 µm at ambient room temperature. To achieve a bow of at most 100 µm at ambient room temperature, it is beneficial to apply sufficient compressive strain with the AlₓGa₁₋ₓN intermediate layer to the GaN-layer of the strain-engineering sub-stack to compensate the tensile strain. This is particularly possible with an AlₓGa₁₋ₓN intermediate layer, with x ≥ 0.5, having a thickness of 5 nm to 25 nm. For example, Al content and thickness of the AlₓGa₁₋ₓN intermediate layer may be chosen taking into account the thermal expansion mismatch between GaN and Si. To this end, it is particularly beneficial to consider the respective total thicknesses of the GaN layers and the substrate. For example, the GaN layers of the strain-engineering sub-stack may be grown with a thickness allowing strain-balancing to compensate thermal expansion during growth to achieve high crystal quality GaN layers in the strain-engineering sub-stack. Suitable thickness may lie in the range of 500 nm to several micrometres, e.g., 2 µm or 3 µm.

The method may further comprise a step of thinning the GaN-on-Si epiwafer starting from the backside of the substrate up to a thickness specified by the SEMI standard for the given wafer diameter. Thinning to SEMI standard thickness is particularly possible since the strain-engineering sub-stack is decoupled from strain that would be induced by the substrate due to its lattice mismatch relative to the epi layers grown on top. It is a particular advantage of the decoupling that also after thinning to SEMI standard thickness, a bow of at most 100 µm at ambient room temperature can be maintained. As a consequence, the thinned GaN-on-Si epiwafer that may then only be comprised of an active layer structure having SEMI standard thickness is suitable for further processing of micro LEDs or transistors or the like in standard semiconductor processing lines.

Preferably, the method further comprises epitaxially growing, at the predefined growth temperature, an active layer structure on top of the strain-engineering sub-stack, said active layer structure comprising a multi-quantum-well structure of III-V nitride materials and being configured to emit light under application of an operating voltage or under optical excitation. Preferably, the n-doped GaN layer underneath the multi-quantum-well structure is grown onto the strain-engineering sub-stack, e.g., as part of the active layer structure.

From the GaN-on-Si epiwafer having the active layer structure, a micro LED structure can be fabricated as part of the method. This may include thinning the GaN-on-Si epiwafer starting from the substrate up to the n-doped GaN layer underneath the multi-quantum-well structure of III-V nitride materials. For example, the GaN-on-Si epiwafer may be thinned to SEMI-standard thickness. Thinning may be performed while the GaN-on-Si epiwafer is placed on a mechanical support.

Disclosed herein is also a micro LED structure comprising an active layer structure comprising a multi-quantum-well structure of III-V nitride materials which is configured to emit light under application of an operating voltage or under optical excitation, wherein, under application of an operating voltage or under optical excitation, the multi-quantum-well structure exhibits an emission wavelength uniformity of +/- 3 nm or less, or of +/- 1 nm or less.

The micro LED structure may be fabricated by processing the GaN-on-Si epiwafer as described before having an active layer structure on top of the strain-engineering sub-stack and by thinning the GaN-on-Si epiwafer starting from the substrate backside up to an n-doped GaN layer underneath the multi-quantum-well structure of III-V nitride materials and by cutting or etching the micro LED structure from the thinned GaN-on-Si epiwafer.

It shall be understood that the aspects described above, and specifically the GaN-on-Si epiwafer of claim 1, and the method of claim 11, have similar and/or identical preferred embodiments, in particular as defined in the dependent claims.

It shall be further understood that a preferred embodiment of the present invention can also be any combination of the dependent claims or above embodiments with the respective independent claim.

These and other aspects of the invention will be apparent from and elucidated with reference to the embodiments described hereinafter with reference to the drawings.

### BRIEF DESCRIPTION OF THE DRAWINGS

- Fig. 1:: shows a GaN-on-Si epiwafer that can be used for fabricating a micro LED structure or a power electronics structure;
- Fig. 2:: shows a self-organized template layer made of AlN;
- Fig. 3:: shows a GaN-on-Si epiwafer with an active layer structure;
- Fig. 4:: shows a GaN-on-Si epiwafer similar to the GaN-on-Si epiwafer of Fig. 3 but having a GaN layer arranged between a surface recovery layer and an AlGaN intermediate layer;
- Fig. 5:: shows a strain-decoupling sub-stack in a schematic cross-sectional view;
- Fig. 6:: shows an atomic force microscopy (AFM) image of an outer surface of a self-organized template layer along a stacking direction of a GaN-on-Si epiwafer;
- Fig. 7:: shows in a), an evolution of the reflectivity and in b) an evolution of the curvature when fabricating a GaN-on-Si epiwafer;
- Fig. 8:: shows a GaN-on-Si epiwafer in a cross section;
- Fig. 9:: shows schematically and exemplary a pyramidal shaped GaN structure that forms on a self-organized template when starting to grow a surface recovery layer;
- Fig. 10:: shows a flow diagram representing a method for fabricating a GaN-on-Si epiwafer;
- Fig. 11:: schematically shows a wafer carrier in a cross-sectional side view, the wafer carrier having a carrier pocket with a bottom surface that has a convex shape;
- Fig. 12:: schematically shows a wafer carrier in a cross-sectional side view, the wafer carrier having a carrier pocket with a bottom surface that exhibits a substantially planar plateau;
- Fig. 13:: schematically shows a wafer carrier in a cross-sectional side view, the wafer carrier having a carrier pocket with a M-shaped bottom surface;
- Fig. 14:: schematically shows a wafer carrier in a top view, the wafer carrier having a carrier pocket with a support surface that is formed by a rim surrounding a bottom surface;
- Fig. 15:: schematically shows a wafer carrier in a top view, the wafer carrier having a carrier pocket with triangular-shaped support posts that comprise respective sections of a support surface;
- Fig. 16:: schematically shows a wafer carrier in a top view, the wafer carrier having a carrier pocket with rectangular-shaped support posts that comprise respective sections of a support surface.

### DETAILED DESCRIPTION OF EMBODIMENTS

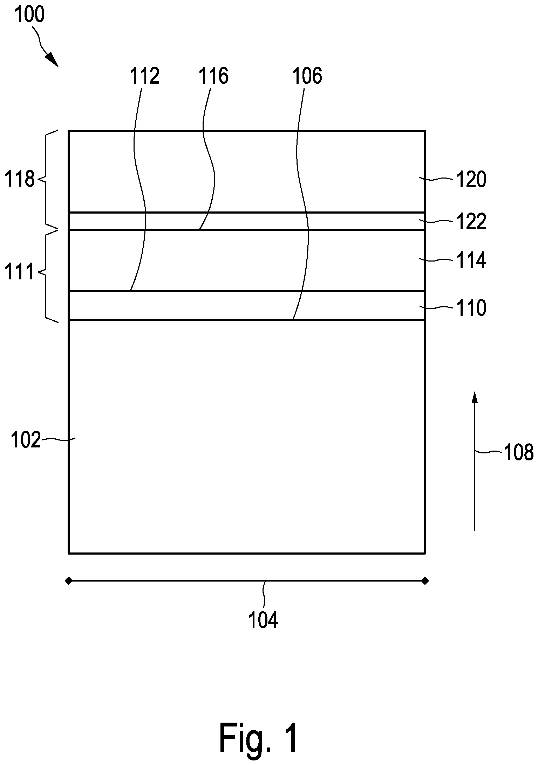

Figure 1 shows a GaN-on-Si epiwafer 100 that can be used for fabricating a micro LED structure or a power electronics structure such as a HEMT. The GaN-on-Si epiwafer 100 comprises a substrate 102 made of silicon. The substrate 102 has a circular base area with a diameter of 300 mm. Yet, in alternative embodiments of the GaN-on-Si epiwafer 100, the substrate 102 may also have a diameter of 150 mm or more, preferably, of 150 mm to 450 mm wherein, preferably, the substrate 102 has a standard diameter of semiconductor technology that is 150 mm, 200 mm, 300 mm or 450 mm. In some embodiments, the substrate 102 may not have a circular base area but a quadratic or polygonal base area.

It is not necessary that the substrate 102 is fully made of silicon, however, it is preferred that at least a substrate surface 106 along a stacking direction 108 of the GaN-on-Si epiwafer 100 is at least partly formed by silicon. For example, parts of the substrate surface 106 that are not formed by silicon may be formed by SiO, SiON, or SiO₂.

The substrate 102 has a thickness along the stacking direction 108 that is 1 mm. Yet, it may be beneficial to use an even thicker substrate of more than 1 mm, for example, of 1.2 mm to 1.6 mm. By using a comparatively thick substrate of 1 mm or more, it may be possible to prevent plastic deformation of the substrate 102 when growing layers on top of the substrate 102.

On the substrate surface 106 of the substrate 102, a strain-decoupling sub stack 111 comprising a self-organized template layer 110 and a surface recovery layer 114 is arranged. The self-organized template layer 110 is made of AIN and comprises a plurality of pits and dislocations. In particular, the self-organized template layer 110 has pits with a density of 1x10⁸ cm⁻² at its template surface 112 and dislocations with a total dislocation density of 1x10¹⁰ cm⁻². The dislocations are distributed within the complete volume of the self-organized template layer 110. Due to the comparatively high pit density and the comparatively high total dislocation density, the self-organized template layer 110 has a comparatively poor crystal quality. The poor crystal quality is intended and yields in combination with the surface recovery layer 114 a decoupling of strain resulting from a lattice mismatch between the silicon substrate 102 and the crystal layers applied on top of the strain-decoupling sub-stack 111 along the stacking direction 108. Strain induced by the silicon substrate 102 is relieved in the surface recovery layer 114 that is substantially strain-free by the presence of the pits and the dislocations in the self-organized template layer 110. It is possible to only have a high pit density to obtain sufficient decoupling of strain. Yet, by having a high total dislocation density, in addition, it is possible to further improve the decoupling of strain.

The pits of the self-organized template layer 110 provide a self-organised template 112 for the growth of the next crystal layer following the self-organized template layer 110 along the stacking direction 108. When growing a layer on top of the self-organised template 112, the pits formed at the self-organized template layer's surface pointing along the stacking direction 108 may be overgrown such that the pits are covered. By overgrowing the pits, an efficient strain relief is achieved in the surface recovery layer 114 thereby decoupling subsequent crystal layers along the stacking direction 108 from strain induced by the substrate 102.

As mentioned before, on top of the self-organized template layer 110, the surface recovery layer 114 is arranged. The surface recovery layer 114 was applied on top of the self-organized template layer 110 by overgrowing the pits of the self-organised template 112 provided by the self-organized template layer 110. Since due to the pits of the self-organized template layer 110 the surface recovery layer grows initially by forming pyramidal structures in a pyramidal growth mode, the surface recovery layer overgrows the pits thereby bending the dislocations to the pyramidal side facets. This mechanism enables an efficient strain relief such that the surface recovery layer 114 is substantially strain-free and provides a smooth surface for the growth of subsequent crystal layers. In particular, there are substantially no pits present at the surface recovery layer's smooth surface 116 pointing along the stacking direction 108. For example, a substantially smooth surface 116 having a reflectivity of more than 35%, for example, of 40% or more, may be achieved by applying first a pyramidal growth mode comprising the formation of pyramidal-shaped GaN structures that promote a bending and annihilation of dislocations followed by a layer-by-layer growth mode for forming the substantially smooth surface 116.

Applied on top of the surface recovery layer 114 and thus on top of the substantially smooth surface 116 there is a strain-engineering sub-stack 118 comprising a GaN layer 120 having a thickness of 3 µm and an Al_{0.6}Ga_{0.4}N intermediate layer 122 having a thickness of 10 nm. The aluminium content of the Al_{0.6}Ga_{0.4}N intermediate layer 122 may be different from 60 % and may instead be 50 % more. Moreover, the thickness of 10 nm may also be selected to be smaller or larger and in particular between 5 nm and 25 nm. By varying the aluminium content and/or the thickness of the Al_{0.6}Ga_{0.4}N intermediate layer 122, it is possible to engineer the strain within the strain-engineering sub-stack 118. That is, with the Al_{0.6}Ga_{0.4}N intermediate layer 122, it is possible to reduce the strain within the strain-engineering sub-stack 118 thereby enabling the growth of the high crystal quality GaN layer 120 having a thickness along the stacking direction of 500 nm or, e.g., of several micrometres, e.g., up to 2 µm or up to 5 µm. In particular, with the Al_{0.6}Ga_{0.4}N intermediate layer 122, it is possible to compensate tensile strain due to thermal expansion mismatch between GaN and Si with a compressive strain component to the GaN layer 120. Thereby, the crystal quality of the GaN layer 120 can be improved.

In the strain-engineering sub-stack 118, the Al_{0.6}Ga_{0.4}N intermediate layer 122 is applied directly on top of the smooth surface 116 of the surface recovery layer 114. The GaN layer 120 follows the Al_{0.6}Ga_{0.4}N intermediate layer 122 along the stacking direction 108 of the GaN-on-Si epiwafer 100. However, it is also possible that the strain-engineering sub-stack 118 starts with the GaN layer 120 such that the Al_{0.6}Ga_{0.4}N intermediate layer 122 is applied on top of the GaN layer 120 along the stacking direction 108.

The strain-engineering sub-stack 118 may comprise further repetitions of the Al_{0.6}Ga_{0.4}N intermediate layer 122 and the GaN layer 120. Having further repetitions of the Al_{0.6}Ga_{0.4}N intermediate layer 122 and the GaN layer 120 may be advantageous, since it is possible that with each repetition, the crystal quality of the respective GaN layer improves. The number of repetitions may thus be chosen such that the most upper GaN layer along the stacking direction 108 has the desired crystal quality. In the further repetitions, the Al content and the thickness of the intermediate layer may vary from one repetition to another. Including further repetitions may be beneficial since with each subsequent repetition it is generally to a comparatively thicker GaN layer. The thicker the GaN layer is, the better is generally also its crystal quality. It is thus often desired to grow comparatively thick GaN layer to achieve an improved crystal quality. The typical thickness of a GaN of a repetition is from 0.5 µm to 5 µm.

A particularly accurate strain-engineering by means of the intermediate layer 122 is possible, since the strain-engineering sub-stack 118 can be grown on a substantially smooth surface 116 provided by the surface recovery layer 114 that is substantially strain-free. It is thus the strain-decoupling sub-stack 111 that provides a decoupling of strain by means of a comparatively high pit density in the self-organized template layer 110 and the subsequent strain relief in the surface recovery layer 114 formed by overgrowing the self-organised template 112 of the self-organized template layer 110 that promotes an efficient and accurate strain balancing in the strain-engineering sub-stack 118. The strain balancing in the strain-engineering sub-stack 118 may include inducing compressive strain in the GaN layers by means of the intermediate layer 122 to enable growth of comparatively high crystal quality GaN layers in the strain-engineering sub-stack 118.

Furthermore, due to the accurate way of strain-engineering favoured by the decoupling of strain to the substrate it is possible that the GaN-on-Si epiwafer 100 has a bow of less than 100 µm at room temperature, for example, less than 80 µm or even less than 50 µm at room temperature. Due to the flat bow of at most 100 µm at room temperature, the GaN-on-Si epiwafer 100 is particularly suitable for the fabrication of a multi-quantum-well structure of III-V nitride materials suitable for fabricating micro LEDs with a emission wavelength uniformity of +/-3 nm or less or even of +/-1 nm or less. Due to the comparatively large diameter of 300 mm or even up to 450 nm or 500 mm, it is possible with the GaN-on-Si epiwafer 100 to fabricate a micro LED structure with high emission wavelength uniformity and with comparatively high economic efficiency.

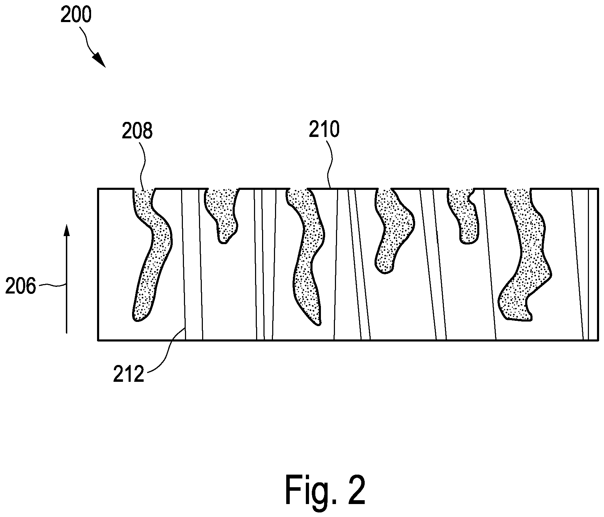

Figure 2 shows a self-organized template layer 200 made of AIN. The self-organized template layer 200 may form a self-organized template layer in a GaN-on-Si epiwafer as described with reference to figure 1.

The self-organized template layer 200 has pits 208 with a pit density of 1x10⁷ cm⁻² to 1x10¹¹ cm⁻² at its template surface 210. The pits 208 have a lateral extension in a direction perpendicular to the stacking direction 206 of a GaN-on-Si epiwafer of 1 nm to 100 nm and, in particular, between 10 nm and 50 nm. In particular, the pits of the self-organized template layer 200 have an average distance in a direction perpendicular to the stacking direction 206 between 200 nm and 2000 nm, which is particularly beneficial for the provision of a self-organised template. By means of the pits 208, a self-organised template is provided by the template surface 210 of the self-organized template layer 200 pointing along the stacking direction 206. When overgrowing the pits 208 with pyramidal structures in a pyramidal growth mode of the surface recovery layer, the pits may not be filled up with material but may be covered. Alternatively, the pits 208 may be at least partly filled and covered when being overgrown. Thereby, the surface recovery layer can be grown strain-free and with a smooth surface for the further growth of subsequent crystal aylets.

Additionally to pits 208, the self-organized template layer 200 comprises a plurality of dislocations 212 having a total dislocation density of 10⁹ cm⁻² or more. The dislocations 212 comprise line defects of which at least 70% have an angle with respect to the stacking direction 206 of 0 degrees to 5 degrees. The dislocations 210 are distributed within the complete volume of the self-organized template layer 200 whereas the pits 208 extend from the template surface 210 into the volume of the self-organized template layer 200.

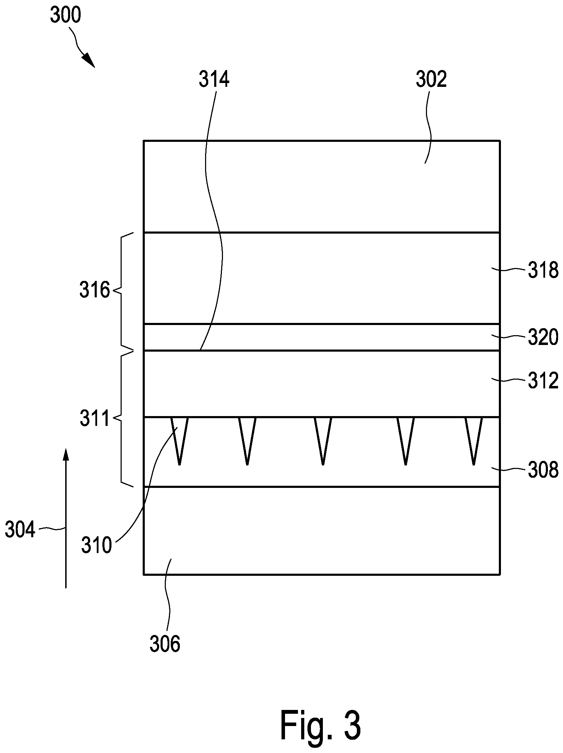

Figure 3 shows a GaN-on-Si epiwafer 300 with an active layer structure 302 that can be an LED structure thus comprising a multi-quantum-well structure or a high power electronics structure.

Along a stacking direction 304 of the GaN-on-Si epiwafer 300, the GaN-on-Si epiwafer 300 comprises a silicon substrate 306 that has a thickness of 1.2 mm and a diameter of 150 mm but may also have a thickness between 1 mm and 1.6 mm and a diameter of 150 mm or more, e.g., 200 mm or 300 mm or of 450 mm. On top of the silicon substrate 306 there is a strain-decoupling sub-stack 311 comprising a self-organized template layer 308 that is an Al-containing layer comprising a plurality of pits 310 and a surface recovery layer 312. The self-organized template layer 308 with its pits 310 serves for decoupling of strain arising from a lattice mismatch between the silicon substrate 306 and further nitride layers applied on top of the strain-decoupling sub-stack 311. The pits 310 of the self-organized template layer 308 form a self-organised template at the template surface that faces along the stacking direction 304 for the growth of the surface recovery layer 312 that is made of GaN. With the surface recovery layer 312, it is possible to significantly reduce the number of dislocations and pits along the stacking direction thereby providing a substantially smooth surface 314 that is used as a growth surface for growing a strain-engineering sub-stack 316 on top of the surface recovery layer 312.

The strain-engineering sub-stack 316 provides a high quality GaN layer 318 that can be used for the fabrication of a micro LED structure having a comparatively high uniformity in the emission wavelength throughout the GaN-on-Si epiwafer 300 of +/- 3 nm or less. The high quality GaN layer 318 may also be used for the fabrication of a high power electronic structure such as a HEMT structure. For obtaining the high quality GaN layer 318, an AlGaN intermediate layer 320 is applied on top of the surface recovery layer 312. By tuning the Al content and/or the thickness of the intermediate layer 320, it is possible to engineer the strain within the strain-engineering sub-stack 316 for improving the crystal quality of the GaN layer 318. It may also be possible to grow the GaN layer 318 directly on top of the surface recovery layer 312 and the intermediate layer 320 on top of the GaN layer 318. Preferably, in this case, a further GaN layer is applied on top of the intermediate layer 320 and used for the fabrication of the active layer structure 302.

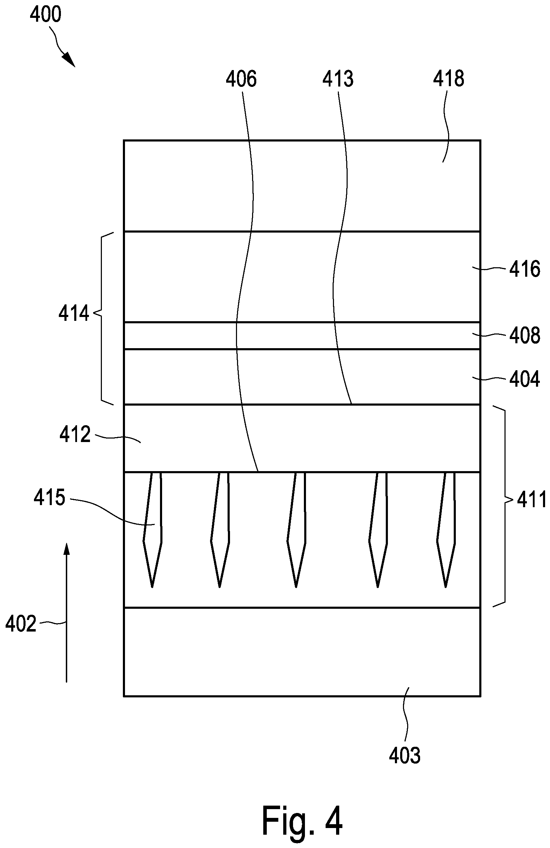

A respective GaN-on-Si epiwafer 400 having a GaN layer 404 arranged between the surface recovery layer 406 and the AlGaN intermediate layer 408 is shown in figure 4. The GaN-on-Si epiwafer 400 shown in figure 4 comprises along a stacking direction 402 of the GaN-on-Si epiwafer 400 a silicon substrate 403 that may be configured according to the substrate 306 of the GaN-on-Si epiwafer 300 as described with reference to figure 3.

As the strain-decoupling sub-stack 311 of GaN-on-Si epiwafer 300, the strain-decoupling sub-stack 411 comprises a self-organized template layer 410 and a surface recovery layer 412 for the decoupling of strain. The self-organized template layer 410 comprises pits 415 that contribute to a decoupling strain-engineering sub-stack 414 from the strain induced by the substrate 403. The self-organized template layer 410 provides a self-organised template 406 for the growth of the surface recovery layer 412 on top of the self-organized template layer 410.

As stated before on top of the substantially smooth surface 413 provided by the surface recovery layer 412, a first high crystal quality GaN layer 404 is provided. The first high crystal quality GaN layer 404 is part of a strain-engineering sub-stack 414 that further comprises the AlGaN intermediate layer 408 and a second high crystal quality GaN layer 416. By applying the first GaN layer 404 on top of the surface recovery layer 406 and below the AlGaN intermediate layer 408, it is possible to further improve the crystal quality of the second GaN layer 416 by means of an accurate strain-engineering achieved by selecting the Al Content and thickness of the AlGaN intermediate layer 408 accordingly. On top of the second high crystal quality GaN layer 416 there is an active layer structure 418 implementing, for example, a micro LED structure with further improved emission wavelength uniformity or a high-power electronic structure such as a HEMT structure.

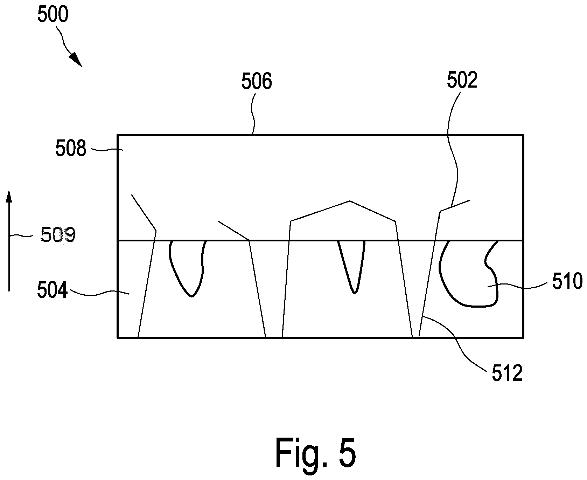

Figure 5 shows a strain-decoupling sub-stack 500 in a schematic cross-sectional view and comprising a self-organized template layer 504 made of AlN arranged on a silicon substrate 506. On top of the self-organized template layer 504, a surface recovery layer 508 made of GaN is arranged.

In the self-organized template layer 504, pits 510 are present. In addition, dislocations 512 are present with a high dislocation density in the self-organized template layer 504 that run substantially vertical within the self-organized template layer 504 and penetrate into the surface recovery layer 508. In the surface recovery layer 508, the total dislocation density is significantly reduced compared to in the self-organized template layer 504. In fact, in the surface recovery layer 508, dislocations 502 bend and disappear, i.e., the dislocations annihilate. As a result, the crystal quality is significantly improved in the surface recovery layer 508 compared to the comparatively poor crystal quality throughout the self-organized template layer 504.

The surface recovery layer 508 may be made of GaN. The surface recovery layer 508 is substantially strain-free and provides a smooth surface 506 for fabricating a strain-engineering sub-stack. The strain-engineering sub-stack may comprise along a stacking direction 509 of self-organized template layer 504 a first AlGaN intermediate layer followed by a first GaN layer followed by a second AlGaN intermediate layer, a second GaN layer, a third AlGaN intermediate layer and a third GaN layer. The first, second and third intermediate layers may have different thicknesses between 5 nm and 25 nm and different aluminium contents of at least 50 %. The thickness of the first, second and third GaN layers may increase along the stacking direction. Likewise, the crystal quality of the first, second and third GaN layers may increases along the stacking direction 509.

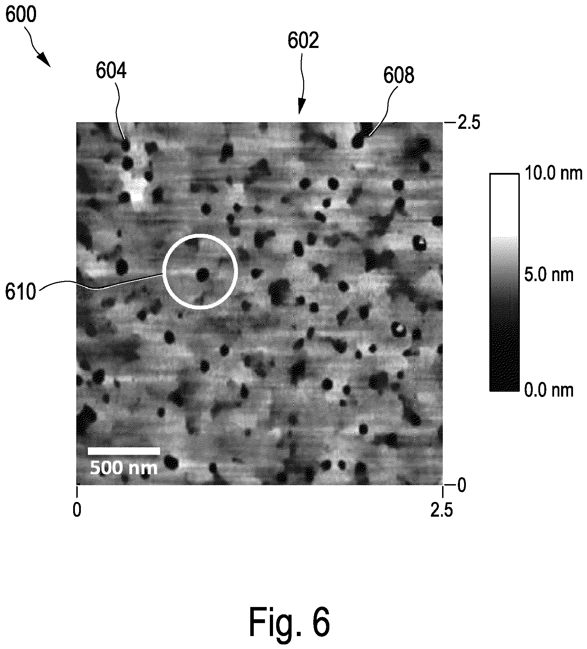

Figure 6 shows an atomic force microscopy (AFM) image 600 of a template surface of a self-organized template layer 602 that points along a stacking direction of a GaN-on-Si epiwafer. The self-organized template layer 602 is made of AIN. As can be seen in the AFM image 600, a plurality of pits 604 are distributed over the self-organized template layer's template surface. The pits 604 are formed by holes having a depth into the self-organized template layer 602 of at least 7 nm. In the AFM image 600, pits 604 are represented by comparatively dark spots having a diameter of between 10 nm and 100 nm. In the AFM image 600 of the self-organized template layer 602, the pits 604 have a pit density of about 10⁹ cm⁻². The pit density can be obtained by counting the pits per unit area. The average distance between the pits is about 500 nm and can be derived by determining the distance between neighbouring pits and then taking the average of the determined distances. In the present case, the average distance is about 500 nm as indicated by the added white circle 610 overlaying the excerpt 600. It may be that several pits 608 are combined at the template surface of the self-organized template layer 602.

The distribution and size of the pits may be controlled by adjusting oxide removal conditions in a reactor for removing a native oxide covering a Si-containing surface of a substrate and the adjustment of the growth conditions while growing the self-organized template layer. In particular, the oxide removal conditions can be adjusted to be comparatively uniform resulting in a surface condition of the Si-containing surface of the substrate that is comparatively uniform, too. The self-organized template layer is then grown on the Si-containing surface of the substrate by means of a columnar growth. Thereby, the growth conditions for growing the self-organized template layer can be controlled to occur uniformly in order to form the pits in the self-organized template layer distributed comparatively uniformly, too.

It has been shown, that oxide removal works particularly well in an H₂ atmosphere. The conditions for native oxide removal may be applied for several minutes. For example, if the processing time is selected to be too short, the native oxide may be not fully removed and prevent growth on top of the substrate. Yet, if the processing time is selected to be too long, the substrate surface may become rough due to H₂ etching into the Si-containing surface after oxide removal.

It has been shown to be beneficial for the growth of a self-organized template layer having a high pit density that the oxide is not removed completely such that native oxide is still partially present on the surface of the substrate. Thereby, a formation of pits of the self-organized template layer can be achieved, in particular, by a columnar growth.

Preferably, the self-organized template layer is grown to have a thickness of between 50 nm and 300 nm, for example, 100 nm and 200 nm. A columnar growth of the AIN self-organized template layer may be promoted by the only partially removed native oxide on the substrate surface as well as by defects that prevent nucleation. For example, it may be that the native oxide as well as defects are not fully overgrown by AIN of the self-organized template layer such that pits form in the self-organized template layer. It is a particular advantage of the just described growth conditions that the self-organized template layer in fact is crystalline and not amorphous and can be fabricated at comparatively high substrate temperatures of more than 1000°C.

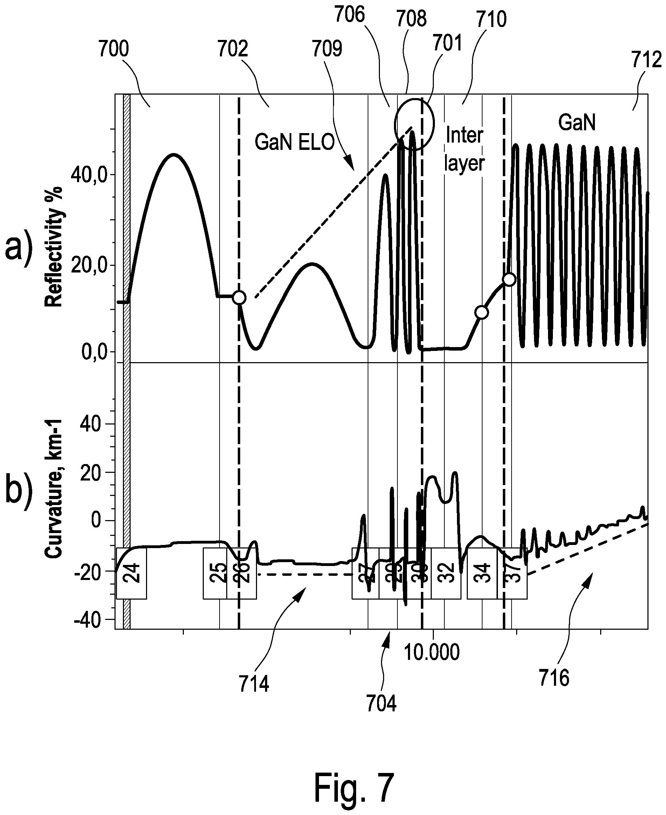

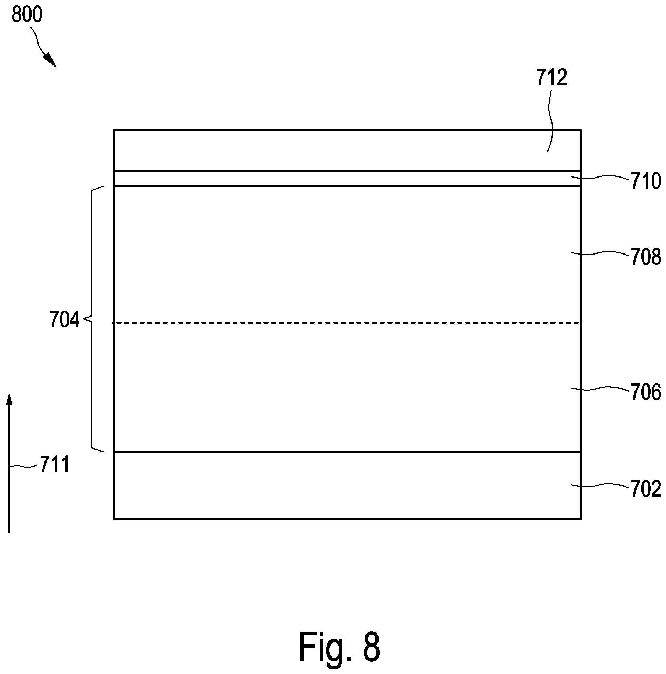

Figure 7 shows at the top in Fig. 7a), an evolution of the reflectivity when fabricating a GaN-on-Si epiwafer 800 a part of which is schematically shown in figure 8. Figure 7 also shows at the bottom in Fig. 7b) an evolution of a curvature during fabrication of the GaN-on-Si epiwafer 800.

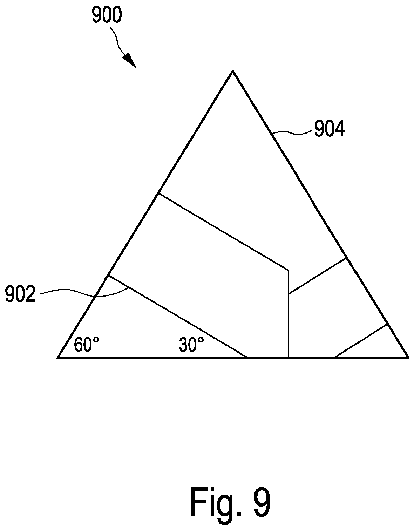

As can be seen in figure 7a), the reflectivity of the substrate 700 is more than 40%. The reflectivity then drops in the self-organized template layer 702 to about 10 %, which can be attributed to the poor crystal quality of the self-organized template layer 702 comprising a plurality of pits and defects. The decoupling of strain from the substrate 700 achieved by the self-organized template layer 702 allows a recovery of the good crystal quality in the surface recovery layer 704 ultimately having a substantially smooth surface that has a comparable surface quality as the surface of the substrate 700 as can be seen in point 701. The surface recovery layer 704 comprises a pyramidal-formed GaN layer 706 that is grown in a pyramidal growth mode. In the pyramidal growth mode, growth of the surface recovery layer 704 starts by a formation of pyramidal shaped GaN structures 900 as shown in figure 9. These pyramidal shaped GaN structures 900 form on a self-organised template provided by the pits of the self-organized template layer 702. In the pyramidal growth mode, the pyramidal-shaped GaN structures 900 of the pyramidal-formed GaN layer 706 overgrow the pits of the self-organised template. The pyramidal growth mode of the first GaN 706 of the surface recovery layer 704 promotes a bending of the dislocations 902 towards the inclined facets 904 of the pyramidal shaped GaN structures 900. As a result, the dislocation density can be significantly reduced in the surface recovery layer 704 along the stacking direction 711 of the GaN-on-Si epiwafer 800. As a result, in a layer-by-layer-formed GaN layer 708 grown in a layer-by-layer growth mode of the surface recovery layer 704, the pit density is significantly reduced and a recovered smooth surface is provided as indicated by the red circle 701. For changing from the pyramidal growth mode to the layer-by-layer growth mode, the growth parameters are controlled to be adapted for the layer-by-layer growth accordingly.

As just stated, after growing the pyramidal-formed GaN layer 706 of the surface recovery layer 704, a layer-by-layer-formed GaN layer 708 of the surface recovery layer 704 is grown in a layer-by-layer growth mode. The growth of the layer-by-layer-formed GaN layer 708 yields a significant recovery of a smooth surface as indicated by the dashed line 709 such that a recovered substantially smooth surface is achieved for the surface recovery layer 704 that has a reflectivity of more than 40 % as indicated by the red circle 701.

On the smooth surface of the surface recovery layer 704, an intermediate layer 710 that is made of AlGaN is applied and used for inducing compressive strain in the GaN layer 712 that is part of a strain-engineering sub-stack of the GaN-on-Si epiwafer 800.

As can be inferred from Fig. 7b), during growth of the surface recovery layer 704, no compressive strain is induced as indicated by the horizontal dashed line 714. Yet, compressive strain is induced in the GaN layer 712 as indicated by the dashed line 716. By inducing compressive strain in the GaN layer 712, it is possible to achieve a comparatively high bow during growth of an active layer structure on top of the strain-engineering sub-stack of the GaN-on-Si epiwafer. During growth of an active layer structure a large bow has the advantage that a uniform temperature distribution between the bottom surface of carrier pocket holding the substrate and substrate can be realised. To this end, the carrier pocket, preferably, has a bottom surface with a convex shape or comprising a convex-shaped bottom surface section, which is curved upwards when seen in a cross-sectional view. Thereby, a substantially constant distance between the carrier pocket's bottom surface and GaN-on-Si epiwafer having a large bow can be established. A uniform temperature distribution is beneficial for the growth of a high quality active layer structure, e.g., comprising quantum wells made of III-V nitride materials such as InGaN. In particular, InGaN is much more sensitive to temperature variations than GaN. Thus, be establishing a uniform temperature distribution, uniform quantum wells made of III-V nitride materials can be fabricated having a superior performance.

It is a further advantage, that after cooling down, the GaN-on-Si epiwafer despite of having a comparatively large bow during growth of the active layer structure has a comparatively low bow of at most 100 µm at room temperature, in particular due to the decoupling of strain, even after thinning of the GaN-on-Si epiwafer. It is therefore possible to thin the GaN-on-Si epiwafer to SEMI standard thickness and to further process electronic or optoelectronic devices from the active layer structure with uniform electronic and/or optoelectronic properties. In particular, due to the comparatively flat bow at room temperature also after thinning of the GaN-on-Si epiwafer 800, the GaN-on-Si epiwafer 800 is particularly suitable for providing an active layer structure implementing a micro LED structure that emits light with comparatively good emission wavelength uniformity of +/- 3 nm or less for further processing in standard semiconductor processing lines.

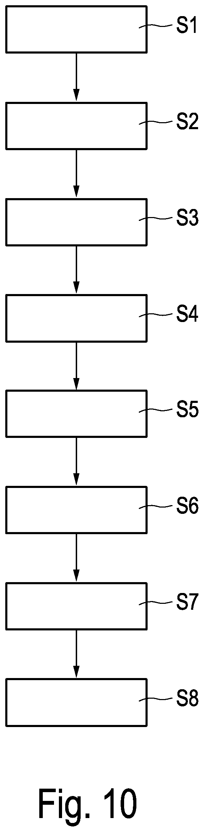

Figure 10 shows a flow diagram representing a method for fabricating a GaN-on-Si epiwafer. By conducting the method described in the following, for example, a GaN-on-Si epiwafer as described with reference to figure 1 may be obtained.

In the method, a wafer carrier is provided (step S1) that is configured for holding a wafer. The wafer carrier is provided in a reactor chamber. The wafer carrier comprises a wafer carrier body having at least one carrier pocket that is configured for accommodating a wafer. The carrier pocket has a support surface for holding the wafer and a bottom surface that is below the wafer and that has a convex shape or comprises a convex shaped bottom surface section. In particular, the bottom surface is at least in parts curved upwards towards a wafer supported by the support surface.

On the support surface of the carrier pocket, a substrate is arranged (step S2) having a circular base area with a diameter of 300 mm. Alternatively, the carrier pocket may be designed for holding a substrate having a diameter of 150 mm or more, preferably, of 150 mm to 450 mm. The base area of the wafer does not necessarily have to be circular. Yet, the carrier pocket may be designed for accommodating a substrate having a non-circular base area, for example, having a quadratic or hexagonal base area.

On top of the substrate, strain-decoupling sub-stack is fabricated comprising growing a self-organized template layer (step S3) by means of epitaxy. The self-organized template layer is made of AIN and is grown to have pits with a pit density of 1x10⁷ cm⁻² to 1x10¹¹ cm⁻². The self-organized template layer particularly serves for decoupling the strain induced by the substrate as well as for providing, by means of the pits, a self-organised template. Prior to growing the self-organized template layer on the substrate, a native oxide may at least partially be removed from the surface of the substrate. Preferably, the self-organized template layer is grown up to a thickness of 50 nm to 300 nm, even more preferably of between 100 nm and 200 nm.

On top of the self-organised template provided by the pits of the self-organized template layer, a surface recovery layer is grown (step S4) by means of epitaxy as part of the strain-decoupling sub-stack. By employing first a pyramidal growth mode, a pyramidal-formed GaN layer of the surface recovery layer is grown. The pyramidal growth mode is thus particularly applied for the initial growth of the surface recovery layer onto the self-organized template of the self-organized template layer. In the pyramidal growth mode, the surface recovery layer starts by forming pyramidal-shaped structures that increase in dimension thereby overgrowing the pits of the self-organized template layer with or without filling them.

Thereby dislocations present in the pyramidal shaped GaN structures band towards the inclined facets and annihilate. As a result of the bending and annihilation of dislocations, the total dislocation density in the surface recovery layer is significantly reduced compared to the total dislocation density of the self-organized template layer that is in the order of 10⁹ cm⁻² or more. The pyramidal growth mode is then changed to a transitional growth mode by controlling the growth parameters accordingly in which the surface recovery layer grows horizontally and vertically. Subsequently, the growth of the surface recovery layer is changed to a layer-by-layer growth mode by again controlling the growth parameters accordingly. Thereby, a surface recovery is achieved resulting in a substantially smooth surface of the surface recovery layer characterised, for example, by a reflectivity that is comparable to the reflectivity of the substrate.

By means of providing the self-organized template layer having a high pit density it thus possible to first overgrow the pits with pyramidal structures. The overgrowth with pyramidal structures causes a bending of the dislocations and/or stops them from propagating further along the stacking direction. As a result, with the layer-by-layer growth mode the surface of the surface recovery layer can be recovered to provide a smooth and substantially strain-free surface for the growth of the strain-engineering sub-stack. It is thus the interplay of providing pits, overgrowing the pits and bending the dislocations to the sides that enables providing a smooth and strain-free surface on which further crystal layers can be grown decoupled from strain induced by the substrate.

Subsequently, on top of the substantially smooth and strain-free surface of the surface recovery layer, a strain-engineering sub-stack is grown (step S5) by means of epitaxy. The strain-engineering sub-stack comprises a GaN layer having a thickness of 1.5 µm to 4.0 µm, and an AlₓGa₁₋ₓN intermediate layer, with x ≥ 0.5 and a thickness of 5 nm to 25 nm. By adjusting the Al content and the thickness of the intermediate layer, it is possible to control a curvature of the GaN-on-Si epiwafer. Controlling the curvature of the GaN-on-Si epiwafer is particularly possible by adjusting the Al content and the thickness of the intermediate layer, which influences the amount of compressive strain induced in the GaN layer of the strain-engineering sub-stack.

For fabricating a micro LED structure from the GaN-on-Si epiwafer, first an active layer structure may be grown on top of the strain-engineering sub-stack (optional step S6). For fabricating the active layer structure the growth parameters are controlled to provide a comparatively large bow of the GaN-on-Si epiwafer. This large bow enables the fabrication of a uniform and high quality active layer structure. The active layer structure preferably comprises a multi-quantum-well structure of III-V nitride materials and is configured to emit light under an application of an operating voltage.

After having grown the strain-engineering sub-stack, the GaN-on-Si epiwafer is allowed to cool down to an ambient temperature (step S7). The thus resulting GaN-on-Si epiwafer has a flat bow of at most 100 µm and is suitable for fabricating a micro LED structure comprising a multi-quantum-well structure of III-V nitride materials, which is configured to emit light under an application of an operating voltage. In particular, an accordingly fabricated micro LED structure may have an emission wavelength uniformity of +/- 3 nm or less.

Furthermore, for fabricating a micro LED structure from the GaN-on-Si epiwafer having an active layer structure, the GaN-on-Si epiwafer is thinned (optional step S8) starting from the substrate backside up to an n-doped GaN layer underneath the active layer structure. Due to the decoupling of strain, even after thinning the GaN-on-Si epiwafer maintains its flat bow of at most 100 µm thus being usable in standard semiconductor processing lines for the fabrication of electronic and/or optoelectronic devices.

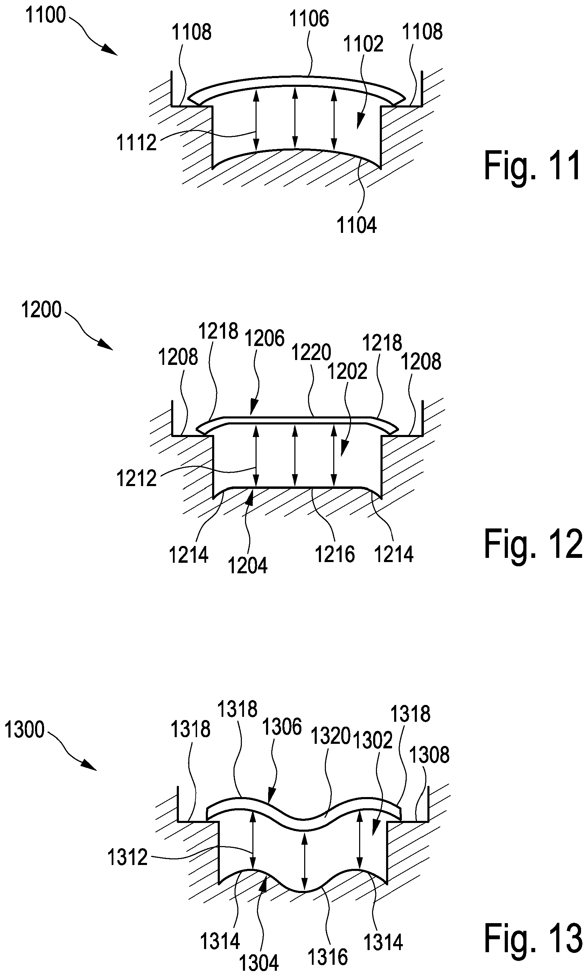

Figure 11 schematically shows a wafer carrier 1100 in a cross-sectional side view. The wafer carrier 1100 has a carrier pocket 1102. The carrier pocket 1102 is configured for accommodating a wafer having a diameter of 300 mm. Alternatively, the carrier pocket 1102 may be configured for accommodating a wafer having a diameter of 150 mm or more, e.g., 150 mm to 450 mm, in particular of either 150 mm, 200 mm, 300 mm or 450 mm. The carrier pocket 1102 is configured for accommodating a wafer having a thickness of 1 mm or more, e.g., of 1 mm to 1.5 mm. To this end, the carrier pocket 1102 comprises a support surface 1108 for supporting a wafer. The carrier pocket 1102 has a bottom surface 1104 with a convex shape, which is curved upwards towards the support surface 1108 as can be seen in the cross-sectional side view.

The wafer carrier 1100 is shown in operation, i.e., having a GaN-on-Si epiwafer 1106 arranged in the carrier pocket 1102. The GaN-on-Si epiwafer 1106 is arranged on the support surface 1108. The GaN-on-Si epiwafer 1106 is configured as described with reference to Fig. 1 and at the present growth stage does not have an active layer structure arranged on top of the strain-engineering sub-stack. At the growth stage exemplary shown in Fig. 11, the GaN-on-Si epiwafer 1106 has a convex bow. The bottom surface 1104 has a convex shape that is configured such that at a predefined bow of the GaN-on-Si epiwafer 1106, a distance 1112 between the GaN-on-Si epiwafer 1106 and the bottom surface 1104 of the carrier pocket 1102 is substantially constant. In other words, at a predefined bow of the GaN-on-Si epiwafer 1106, the curvature of the GaN-on-Si epiwafer 1106 substantially corresponds to the convex shape of the bottom surface 1104. This is advantageous, since an active layer structure can be grown on top of the strain-engineering sub-stack with uniform heat distribution below the GaN-on-Si epiwafer. In particular, while growing the active layer structure on top of the strain-engineering sub-stack, the growth conditions are controlled such that a predefined bow of the GaN-on-Si epiwafer 1106 is maintained. Preferably, the vertical distance from the bottom surface to the support surface may be between 0.05 mm and 1 mm, e.g., between 1mm and 0.25 mm along the diameter of the GaN-on-Si epiwafer 1106 if the GaN-on-Si epiwafer 1106 has a predefined bow.

Thereby, it is possible to establish at least similar growth conditions along the diameter of the GaN-on-Si epiwafer 1106 which enables the growth of a uniform active layer structure, e.g., an active layer structure as described with reference to Figs. 3 or 4. An active layer structure grown with uniform heat distribution below the GaN-on-Si epiwafer 1106 may have substantially uniform electronic and/or optoelectronic properties along the diameter of the GaN-on-Si epiwafer 1106. From such an active layer structure, electronic or optoelectronic devices such as micro LEDs may be fabricated with high yield. For example, micro LEDs may be fabricated from the GaN-on-Si epiwafer 1106 that show excellent emission wavelength uniformity of +/- 3 nm or less, or of +/- 1 nm or less.

Figure 12 schematically shows a wafer carrier 1200 in a cross-sectional side view. The wafer carrier 1200 has a carrier pocket 1202. The wafer carrier 1200 is configured the same way as the wafer carrier 1100 described with reference to Fig. 11, except for the bottom surface 1204 of the carrier pocket 1202. The bottom surface 1204 of the carrier pocket 1202 is not constantly curved as is the bottom surface 1104 of the carrier pocket 1102, but has a convex curved outer rim 1214 that surrounds a substantially planar plateau 1216 located in the centre of the bottom surface 1204. The substantially planar plateau 1216 is parallel to a support surface 1208 of the carrier pocket 1202.

Such a wafer carrier 1200 may be useful to grow an active layer structure on top of a strain-engineering sub-stack of a GaN-on-Si epiwafer 1206 that likewise shows a convex curved outer rim 1218 surrounding a substantially planar plateau 1220 located in the centre of the GaN-on-Si epiwafer 1206. In Fig. 12, a corresponding situation is exemplary shown, in which the wafer carrier 1200 is arranged on the carrier pocket's support surface 1208 and is employed to grow an active layer structure on top of a strain-engineering sub-stack of the GaN-on-Si epiwafer 1206. As can be seen in Fig. 12, the growth conditions are controlled such that a distance 1212 between the GaN-on-Si epiwafer 1206 and the bottom surface 1204 of the carrier pocket 1202 is substantially constant.

Figure 13 schematically shows a wafer carrier 1300 in a cross-sectional side view. The wafer carrier 1300 has a carrier pocket 1302 with an M-shaped bottom surface 1304. Accordingly, the M-shaped bottom surface 1304 comprises a convex-shaped rim 1314 that surrounds a concave-shaped central portion 1316 of the bottom surface 1304.

Like wafer carriers 1100 and 1200 of Figs. 11 and 12, respectively, the wafer carrier 1300, too, is shown during operation, i.e., having a GaN-on-Si epiwafer 1306 arranged on a support surface 1308 of the carrier pocket 1302. The growth conditions are controlled such that the GaN-on-Si epiwafer 1306, too, has an M-shaped curvature with an outer convex-shaped rim 1318 that surrounds a concave-shaped central portion 1320. Such an M-shape may occur during growth due to gravity, in particular, when using a GaN-on-Si epiwafer 1306 with large diameters, e.g., of 300 mm or more. During growth of an active layer structure on top of a strain-engineering sub-stack of the GaN-on-Si epiwafer 1306, the growth conditions can be controlled such that a distance 1312 between the GaN-on-Si epiwafer 1306 and the bottom surface 1304 of the carrier pocket 1302 is substantially constant along the diameter of the GaN-on-Si epiwafer 1306.

Each of the wafer carriers 1100, 1200, 1300 as described with reference to Figs. 11, 12, and 13, respectively, may be used in a method as described with reference to Fig. 10 for fabricating a GaN-on-Si epiwafer.

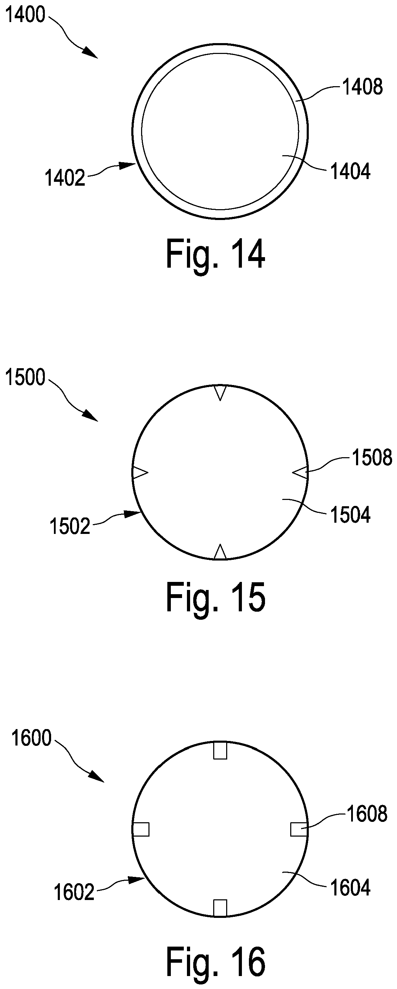

Figures 14, 15 and 16 schematically show wafer carriers 1400, 1550, and 1600, respectively, in a top view. The wafer carrier 1400 has a carrier pocket 1402 with a support surface 1408 that is formed by a rim surrounding a bottom surface 1404. The wafer carrier 1500 has a carrier pocket with triangular-shaped support posts 1508 that comprise respective sections of a support surface surrounding a bottom surface 1504. The number of triangular-shaped support posts 1508 can be four as in the present example but in general may be three or larger. The wafer carrier 1600 has a carrier pocket 1602 with rectangular-shaped support posts 1608 that comprise respective sections of a support surface surrounding a bottom surface 1604. The number of rectangular-shaped support posts 1608 can be four as in the present example but in general may be three or larger. A support surface implemented as a rim 1408 as in wafer carrier 1400 or as triangular-shaped support posts 1508 as in wafer carrier 1500 or as rectangular-shaped support posts 1608 as in wafer carrier 1600 may be used in each of wafer carriers 1100, 1200 and 1300 to implement the support surface 1108, 1208 and 1308, respectively.

Other variations to the disclosed embodiments can be understood and effected by those skilled in the art in practicing the claimed invention, from a study of the drawings, and detailed description, within the scope of the invention as defined by the appended claims.

In the claims, the word "comprising" does not exclude other elements or steps, and the indefinite article "a" or "an" does not exclude a plurality.

Any reference signs in the claims should not be construed as limiting the scope.

## Claims

1. A GaN-on-Si epiwafer (100, 300, 400, 800) forming a layer stack comprising along a stacking direction (108, 304, 402, 711):
- a substrate (102, 306, 403) having a diameter of 150 mm or more, preferably, of 150 mm to 450 mm, in at least one direction that is perpendicular to the stacking direction and a substrate surface (106) along the stacking direction that is at least partly formed by silicon,
- a strain-decoupling sub-stack (111, 311, 411) comprising
- a self-organized template layer (110, 308, 410) arranged directly on the substrate, the self-organized template layer comprising pits (310, 415), said pits having a pit density of 1x10⁷ cm⁻² to 1x10¹¹ cm⁻², and
- a surface recovery layer (114, 312, 412) arranged directly on the self-organized template layer and comprising GaN, the surface recovery layer having a smooth surface (116, 413) with a reflectivity of 35 % to 50 % or a surface roughness of 1 nm or less that points along the stacking direction, and
- a strain-engineering sub-stack (118, 316, 414) arranged on the surface recovery layer and comprising at least one GaN layer (120, 318, 404, 416) and at least one AlₓGa₁₋ₓN intermediate layer (122, 320, 408), with x ≥ 0.5, the GaN layer having a thickness of 0.5 µm to 4.0 µm, the AlₓGa₁₋ₓN intermediate layer having a thickness of 5 nm to 25 nm, wherein
- the GaN-on-Si epiwafer has a bow of at most 100 µm at room temperature.

2. The GaN-on-Si epiwafer of claim 1, further comprising an active layer structure (302, 418) arranged on the strain-engineering sub-stack, the active layer structure comprising a multi-quantum-well structure of III-V nitride materials, which is configured to emit light under application of an operating voltage or under optical excitation, and/or comprising a lasing structure configured for emitting laser radiation and/or comprising a transistor structure.

3. The GaN-on-Si epiwafer of claim 2, wherein, under application of an operating voltage or under optical excitation, the multi-quantum-well structure exhibits an emission wavelength uniformity of +/- 3 nm or less, or of +/- 1 nm or less.

4. The GaN-on-Si epiwafer of at least one of the preceding claims, wherein the self-organized template layer has a total dislocation density of 10⁹ cm⁻² or more throughout a thickness of the self-organized template layer.

5. The GaN-on-Si epiwafer of at least one of the preceding claims, wherein the self-organized template layer comprises line defects of which at least 50 %, or at least 70 % or at least 90 %, have an angle with respect to the stacking direction of 0° to 20°, or in the range of 0° to 2°.

6. The GaN-on-Si epiwafer of at least one of the preceding claims, wherein the strain-engineering sub-stack comprises at least two repetitions of a sequence of the GaN layer and the AlₓGa₁₋ₓN intermediate layer, or of the AlₓGa₁₋ₓN intermediate layer and the GaN layer, with x ≥ 0.5.

7. The GaN-on-Si epiwafer of at least one of the preceding claims, wherein the smooth surface of the surface recovery layer has a reflectivity of 40 % to 45 %.

8. The GaN-on-Si epiwafer of at least one of the preceding claims, wherein the surface recovery layer comprises dislocations that bend under an angle of 15° to 45° with respect to an interface formed between the self-organized template layer and the surface recovery layer.

9. The GaN-on-Si epiwafer of at least one of the preceding claims, wherein pits of the self-organized template layer have a pit size of 1 nm to 100 nm.

10. The GaN-on-Si epiwafer of at least one of the preceding claims, wherein the pits of the self-organized template layer have an average pit distance between adjacent pits that is in the range of 200 nm to 2000 nm.

11. A method of fabricating a GaN-on-Si epiwafer, the method comprising the steps of
- providing a wafer carrier (1100, 1200, 1300, 1400, 1500, 1600) for holding a substrate, the wafer carrier comprising
a wafer carrier body having at least one carrier pocket (1102, 1202, 1302, 1402, 1502, 1602) for accommodating a substrate, the carrier pocket having
- a bottom surface (1104, 1204, 1304, 1404, 1504, 1604), and
- a support surface (1108, 1208, 1308, 1408) located at a predefined vertical distance from the bottom surface, the support surface being configured for supporting the substrate,
wherein the bottom surface has a convex shape or comprises a convex-shaped bottom surface section, which is curved upwards when seen in a cross-sectional view,
- arranging a substrate having a diameter of 150 mm or more, preferably, of 150 mm to 450 mm in at least one direction that is perpendicular to the stacking direction and having a substrate surface along the stacking direction that is at least partly formed by silicon, on the support surface of the wafer carrier's carrier pocket,
- fabricating a strain-decoupling sub-stack comprising
- epitaxially growing a self-organized template layer directly on top of the substrate such that the self-organized template layer has a pit density of 1x10⁷ cm⁻² to 1x10¹¹ cm⁻², and
- epitaxially growing a surface recovery layer comprising GaN on the self-organized template layer until the surface recovery layer has a smooth surface with a reflectivity of 35 % to 50 % or a surface roughness of 1 nm or less that points along the stacking direction,
- controlling a curvature of the GaN-on-Si epiwafer by epitaxially growing, using at least one predefined growth temperature a strain-engineering sub-stack on top of the surface recovery layer, the strain-engineering sub-stack comprising at least one GaN layer and at least one AlₓGa₁₋ₓN intermediate layer, with x ≥ 0.5, the GaN layer having a thickness of 0.5 µm to 4.0 µm, the AlₓGa₁₋ₓN intermediate layer having a thickness of 5 nm to 25 nm, and
- allowing the GaN-on-Si epiwafer to cool down to an ambient room temperature.

12. The method of claim 11, wherein controlling the curvature of the GaN-on-Si epiwafer further comprises adjusting an Al content or thickness of the AlₓGa₁₋ₓN intermediate layer to achieve a convex curvature with a normal distance between the bottom surface of the carrier pocket and the GaN-on-Si epiwafer that is constant across the epiwafer diameter at growth temperature.

13. The method of claim 11 and 12, further comprising epitaxially growing an active layer structure on top of the strain-engineering sub-stack, said active layer structure comprising a multi-quantum-well structure of III-V nitride materials and being configured to emit light under application of an operating voltage or under optical excitation.

14. The method of claim 13, wherein growing the active layer structure comprises growing an n-doped GaN layer and on top of the n-doped GaN layer the multi-quantum-well structure and wherein fabricating a micro LED structure from the GaN-on-Si epiwafer includes thinning the GaN-on-Si epiwafer starting from the substrate backside up to the n-doped GaN layer underneath the multi-quantum-well structure.

## Patentansprüche

1. GaN-on-Si-Epiwafer (100, 300, 400, 800), der entlang einer Stapelrichtung (108, 304, 402, 711) einen Schichtstapel bildet, aufweisend:
- ein Substrat (102, 306, 403) mit einem Durchmesser von 150 mm oder mehr, vorzugsweise von 150 mm bis 450 mm, in mindestens einer Richtung, die senkrecht zu der Stapelrichtung verläuft und einer Substratoberfläche (106) entlang der Stapelrichtung, die zumindest teilweise durch Silizium gebildet ist,
- einen spannungsentkoppelnden Teilstapel (111, 311, 411) aufweisend
- eine selbstorganisierte Template-Schicht (110, 308, 410), die direkt auf dem Substrat angeordnet ist, wobei die selbstorganisierte Template-Schicht, Vertiefungen (310, 415) mit einer Vertiefungsdichte von 1x10⁷ cm⁻² bis 1x10¹¹ cm⁻² aufweist, und
- eine Oberflächenwiederherstellungsschicht (114, 312, 412), die direkt auf der selbstorganisierten Template-Schicht angeordnet ist und GaN umfasst, wobei die Oberflächenwiederherstellungsschicht eine glatte Oberfläche (116, 413) mit einer Reflektivität von 35 % bis 50 % oder einer Oberflächenrauigkeit von 1 nm oder weniger hat, die entlang der Stapelrichtung zeigt, und
- einen spannungsbeeinflussenden Teilstapel (118, 316, 414), der auf der Oberflächenwiederherstellungsschicht angeordnet ist und mindestens eine GaN-Schicht (120, 318, 404, 416) und mindestens eine AlₓGa₁₋ₓN-Zwischenschicht (122, 320, 408), mit x ≥ 0,5 aufweist, wobei die GaN-Schicht eine Dicke von 0,5 µm bis 4,0 µm und die AlₓGa₁-ₓN-Zwischenschicht eine Dicke von 5 nm bis 25 nm hat, wobei
- der GaN-on-Si-Epiwafer bei Raumtemperatur eine Krümmung von höchstens 100 µm hat.

2. GaN-on-Si-Epiwafer nach Anspruch 1, weiterhin aufweisend eine aktive Schichtstruktur (302, 418), die auf dem spannungsbeeinflussenden Teilstapel angeordnet ist, wobei die aktive Schichtstruktur eine Multi-Quantum-Well-Struktur aus III-V-Nitrid-Materialien aufweist, die ausgebildet ist, unter Anlegen einer Betriebsspannung oder unter optischer Anregung Licht zu emittieren, und/oder eine Laserstruktur aufweist, die ausgebildet ist, Laserstrahlung zu emittieren und/oder eine Transistorstruktur aufweist.

3. GaN-on-Si-Epiwafer nach Anspruch 2, wobei die Multi-Quantum-Well-Struktur unter Anlegen einer Betriebsspannung oder unter optischer Anregung eine Emissionswellenlängengleichförmigkeit von +/- 3 nm oder weniger oder von +/- 1 nm oder weniger aufweist.

4. GaN-on-Si-Epiwafer nach mindestens einem der vorstehenden Ansprüche, wobei die selbstorganisierte Template-Schicht eine Gesamtversetzungsdichte von 10⁹ cm⁻² oder mehr über eine gesamte Dicke der selbstorganisierten Template-Schicht aufweist.

5. GaN-on-Si-Epiwafer nach mindestens einem der vorstehenden Ansprüche, wobei die selbstorganisierte Template-Schicht Liniendefekte aufweist, von denen mindestens 50 % oder mindestens 70 % oder mindestens 90 % einen Winkel von 0° bis 20° oder im Bereich von 0° bis 2° in Bezug auf die Stapelrichtung aufweisen.

6. GaN-on-Si-Epiwafer nach mindestens einem der vorstehenden Ansprüche, wobei der spannungsbeeinflussenden Teilstapel mindestens zwei Wiederholungen einer Sequenz aus der GaN-Schicht und der AlₓGa₁-ₓN-Zwischenschicht oder aus der AlₓGa₁-ₓN-Zwischenschicht und der GaN-Schicht aufweist, wobei x≥ 0,5 ist.

7. GaN-on-Si-Epiwafer nach mindestens einem der vorstehenden Ansprüche, wobei die glatte Oberfläche der Oberflächenwiederherstellungsschicht eine Reflektivität von 40 % bis 45 % aufweist.

8. GaN-on-Si-Epiwafer nach mindestens einem der vorstehenden Ansprüche, wobei die Oberflächenwiederherstellungsschicht Versetzungen aufweist, die sich unter einem Winkel von 15° bis 45° in Bezug auf eine Grenzfläche biegen, die zwischen der selbstorganisierten Template-Schicht und der Oberflächenwiederherstellungsschicht gebildet ist.

9. GaN-on-Si-Epiwafer nach mindestens einem der vorstehenden Ansprüche, wobei die Vertiefungen der selbstorganisierten Template-Schicht eine Vertiefungsgröße von 1 nm bis 100 nm haben.

10. GaN-on-Si-Epiwafer nach mindestens einem der vorstehenden Ansprüche, wobei die Vertiefungen der selbstorganisierten Template-Schicht einen durchschnittlichen Vertiefungsabstand zwischen benachbarten Vertiefungen im Bereich von 200 nm bis 2000 nm haben.

11. Verfahren zur Herstellung eines GaN-on-Si-Epiwafers, wobei das Verfahren die Schritte umfasst
- Bereitstellen eines Waferträgers (1100, 1200, 1300, 1400, 1500, 1600) zum Halten eines Substrats, wobei der Waferträger einen Waferträgerkörper mit mindestens einer Trägertasche (1102, 1202, 1302, 1402, 1502, 1602) zur Aufnahme eines Substrats aufweist, wobei die Trägertasche aufweist
- eine Bodenfläche (1104, 1204, 1304, 1404, 1504, 1604), und
- eine Stützfläche (1108, 1208, 1308, 1408) die sich in einem vordefinierten vertikalen Abstand von der Bodenfläche befindet, wobei die Stützfläche zum Stützen des Substrats ausgebildet ist,
wobei die Bodenfläche eine konvexe Form aufweist oder einen konvex geformten Bodenflächenabschnitt aufweist, der nach oben gewölbt ist, wenn er in einer Querschnittsansicht betrachtet wird,
- Anordnen eines Substrats mit einem Durchmesser von 150 mm oder mehr, vorzugsweise von 150 mm bis 450 mm in mindestens einer Richtung, die senkrecht zu der Stapelrichtung zeigt und mit einer Substratfläche entlang der Stapelrichtung, die zumindest teilweise aus Silizium besteht, auf der Stützfläche der Trägertasche des Waferträgers,
- Herstellen eines spannungsentkoppelnden Teilstapels, umfassend
- epitaktisches Aufwachsen einer selbstorganisierten Template-Schicht direkt auf dem Substrat, so dass die selbstorganisierte Template-Schicht eine Vertiefungsdichte von 1x10⁷ cm⁻² bis 1x10¹¹ cm⁻² aufweist, und
- epitaktisches Aufwachsen einer GaN aufweisenden Oberflächenwiederherstellungsschicht auf der selbstorganisierten Template-Schicht, bis die Oberflächenwiederherstellungsschicht eine glatte Oberfläche mit einer Reflektivität von 35 % bis 50 % oder eine Oberflächenrauigkeit von 1 nm oder weniger aufweist, die entlang der Stapelrichtung zeigt,
- Einstellen einer Krümmung des GaN-on-Si-Epiwafers durch epitaktisches Aufwachsen eines spannungsbeeinflussenden Teilstapels auf der Oberflächenwiederherstellungsschicht, unter Verwendung mindestens einer vordefinierten Wachstumstemperatur, wobei der spannungsbeeinflussende Teilstapel mindestens eine GaN-Schicht und mindestens eine AlₓGa₁-ₓN-Zwischenschicht aufweist, wobei x ≥ 0,5 ist, wobei die GaN-Schicht eine Dicke von 0,5 µm bis 4,0 µm hat, die AlₓGa₁-ₓN-Zwischenschicht eine Dicke von 5 nm bis 25 nm hat, und
- Abkühlen lassen des GaN-on-Si-Epiwafers auf Raumtemperatur.

12. Verfahren nach Anspruch 11, wobei die Steuerung der Krümmung des GaN-on-Si-Epiwafers weiterhin das Einstellen eines Al-Gehalts oder der Dicke der AlₓGa₁₋ₓN-Zwischenschicht umfasst, um eine konvexe Krümmung mit einem Normalabstand zwischen der Bodenfläche der Trägertasche und dem GaN-on-Si-Epiwafer zu erreichen, der bei Wachstumstemperatur im Wesentlichen konstant über den Epiwafer-Durchmesser ist.

13. Verfahren nach Anspruch 11 und 12, das weiterhin das epitaktische Aufwachsen einer aktiven Schichtstruktur auf dem spannungsbeeinflussenden Teilstapel umfasst, wobei die aktive Schichtstruktur eine Multi-Quantum-Well-Struktur aus III-V-Nitrid-Materialien umfasst und ausgebildet ist, unter Anlegen einer Betriebsspannung oder unter optischer Anregung Licht zu emittieren.

14. Verfahren nach Anspruch 13, wobei das Aufwachsen der aktiven Schichtstruktur das Aufwachsen einer n-dotierten GaN-Schicht und auf der n-dotierten GaN-Schicht die Multi-Quantum-Well-Struktur umfasst und wobei die Herstellung einer Mikro-LED-Struktur aus dem GaN-auf-Si-Epiwafer das Dünnen des GaN-on-Si-Epiwafers beginnend von der Substratrückseite bis zu der n-dotierten GaN-Schicht unterhalb der Multi-Quantum-Well-Struktur umfasst.

## Revendications

1. Une plaquette épitaxiale de GaN sur Si (100, 300, 400, 800) formant un empilement de couches comprenant le long d'une direction d'empilement (108, 304, 402, 711) :
- un substrat (102, 306, 403) ayant un diamètre de 150 mm ou plus, de préférence de 150 mm à 450 mm, dans au moins une direction perpendiculaire à la direction d'empilement et une surface de substrat (106) le long de la direction d'empilement qui est au moins en partie formée de silicium,
- un sous-empilement de découplage des contraintes (111, 311, 411) comprenant
- une couche de gabarit auto-organisée (110, 308, 410) disposée directement sur le substrat, la couche de gabarit auto-organisée comprenant des piqûres (310, 415), ayant une densité des piqûres de 1x10⁷ cm⁻² à 1x10¹¹ cm⁻², et
- une couche de recouvrement de surface (114, 312, 412) disposée directement sur la couche de gabarit auto-organisée et comprenant du GaN, la couche de recouvrement de surface ayant une surface lisse (116, 413) avec une réflectivité de 35% à 50 % ou une rugosité de surface de 1 nm ou moins qui pointe le long de la direction d'empilement, et
- un sous-empilement d'ingénierie des contraintes (118, 316, 414) disposé sur la couche de recouvrement de surface et
comprenant au moins une couche de GaN (120, 318, 404, 416) et au moins une couche intermédiaire de AlₓGa₁₋ₓN (122, 320, 408), avec x ≥ 0,5, la couche de GaN ayant une épaisseur de 0,5 µm à 4,0 µm, la couche intermédiaire de AlₓGa₁₋ₓN ayant une épaisseur de 5 nm à 25 nm, dans laquelle
- la plaquette épitaxiale de GaN sur Si a une courbure d'au plus 100 µm à température ambiante.

2. Plaquette épitaxiale de GaN sur Si selon la revendication 1, comprenant en outre une structure de couche active (302, 418) disposée sur le sous-empilement d'ingénierie des contraintes, la structure de couche active comprenant une structure à puits quantiques multiples de matériaux nitrures III-V, qui est configurée pour émettre de la lumière sous l'application d'une tension de fonctionnement ou sous une excitation optique, et/ou comprenant une structure laser configurée pour émettre un rayonnement laser et/ou comprenant une structure de transistor.

3. Plaquette épitaxiale de GaN sur Si selon la revendication 2, dans laquelle, sous l'application d'une tension de fonctionnement ou sous excitation optique, la structure à puits quantiques multiples présente une uniformité de longueur d'onde d'émission de +/- 3 nm ou moins, ou de +/- 1 nm ou moins.

4. Plaquette épitaxiale de GaN sur Si selon au moins l'une des revendications précédentes, dans laquelle la couche de gabarit auto-organisée présente une densité de dislocation totale de 10⁹ cm⁻² ou plus sur toute l'épaisseur de la couche de gabarit auto-organisée.

5. Plaquette épitaxiale de GaN sur Si selon au moins l'une des revendications précédentes, dans laquelle la couche de gabarit auto-organisée comprend des défauts de ligne dont au moins 50 %, ou au moins 70 % ou au moins 90 %, présentent un angle par rapport à la direction d'empilement de 0° à 20°, ou dans la plage de 0° à 2°.

6. Plaquette épitaxiale de GaN sur Si selon au moins l'une des revendications précédentes, dans laquelle la sous-pile d'ingénierie des contraintes comprend au moins deux répétitions d'une séquence de la couche GaN et de la couche intermédiaire AlₓGa₁₋ₓN, ou de la couche intermédiaire AlₓGa₁₋ₓN et de la couche GaN, avec x ≥ 0,5.

7. Plaquette épitaxiale de GaN sur Si selon au moins l'une des revendications précédentes, dans laquelle la surface lisse de la couche de récupération de surface présente une réflectivité de 40 % à 45 %.

8. Plaquette épitaxiale de GaN sur Si selon au moins l'une des revendications précédentes, dans laquelle la couche de récupération de surface comprend des dislocations qui se courbent sous un angle de 15° à 45° par rapport à une interface formée entre la couche de gabarit auto-organisée et la couche de récupération de surface.

9. Plaquette épitaxiale de GaN sur Si selon au moins l'une des revendications précédentes, dans laquelle les piqûres de la couche de gabarit auto-organisée ont une taille de piqûre de 1 nm à 100 nm.

10. Plaquette épitaxiale de GaN sur Si selon au moins l'une des revendications précédentes, dans laquelle les piqûres de la couche de gabarit auto-organisée ont une distance de piqûre moyenne entre des piqûres adjacents qui est comprise entre 200 nm et 2000 nm.

11. Procédé de fabrication d'une plaquette épitaxiale de GaN sur Si, le procédé comprenant les étapes consistant à :
- fournir un support de plaquette (1100, 1200, 1300, 1400, 1500, 1600) pour maintenir un substrat, le support de plaquette comprenant un corps de support de plaquette comportant au moins une poche de support (1102, 1202, 1302, 1402, 1502, 1602) pour loger un substrat, la poche de support comportant
- une surface inférieure (1104, 1204, 1304, 1404, 1504, 1604), et
- une surface de support (1108, 1208, 1308, 1408) située à une distance verticale prédéfinie de la surface inférieure, la surface de support étant configurée pour supporter le substrat,
dans lequel la surface inférieure a une forme convexe ou comprend une section de surface inférieure de forme convexe, qui est courbée vers le haut lorsqu'elle est vue en coupe transversale,
- disposer un substrat ayant un diamètre de 150 mm ou plus, de préférence de 150 mm à 450 mm dans au moins une direction qui est perpendiculaire à la direction d'empilement et ayant une surface de substrat le long de la direction d'empilement qui est au moins partiellement formée par du silicium, sur la surface de support de la poche de support du support de plaquette,
- fabriquer un sous-empilement de découplage des contraintes comprenant les étapes consistant à :
- faire croître par épitaxie une couche de gabarit auto-organisée directement sur le dessus du substrat de telle sorte que la couche de gabarit auto-organisée ait une densité de piqûres de 1x10⁷ cm⁻² à 1x10¹¹ cm⁻², et
- faire croître par épitaxie une couche de récupération de surface comprenant du GaN sur la couche de gabarit auto-organisée jusqu'à ce que la couche de récupération de surface ait une surface lisse avec une réflectivité de 35 % à 50 % ou une rugosité de surface de 1 nm ou moins qui pointe le long de la direction d'empilement,
- contrôler une courbure de la plaquette épitaxiale de GaN sur Si par l'étape consistant à faire croître par épitaxie, en utilisant au moins une température de croissance prédéfinie, une sous-pile d'ingénierie des contraintes au-dessus de la couche de récupération de surface, la sous-pile d'ingénierie des contraintes comprenant au moins une couche de GaN et au moins une couche intermédiaire AlₓGa₁₋ₓN, avec x≥ 0,5, la couche de GaN ayant une épaisseur de 0,5 µm à 4,0 µm, la couche intermédiaire AlₓGa₁₋ₓN ayant une épaisseur de 5 nm à 25 nm, et
- permettre à la plaquette épitaxiale de GaN sur Si de se refroidir jusqu'à une température ambiante.

12. Procédé selon la revendication 11, dans lequel le contrôle de la courbure de la plaquette épitaxiale de GaN sur Si comprend en outre l'ajustement d'une teneur en Al ou de l'épaisseur de la couche intermédiaire AlₓGa₁₋ₓN pour obtenir une courbure convexe avec une distance normale entre la surface inférieure de la poche de support et la plaquette épitaxiale de GaN sur Si qui est constante sur tout le diamètre de la plaquette épitaxiale à la température de croissance.

13. Procédé selon les revendications 11 et 12, comprenant en outre la croissance épitaxiale d'une structure de couche active au-dessus du sous-empilement d'ingénierie des contraintes, ladite structure de couche active comprenant une structure à puits quantiques multiples de matériaux nitrures III-V et étant configurée pour émettre de la lumière sous l'application d'une tension de fonctionnement ou sous une excitation optique.

14. Procédé selon la revendication 13, dans lequel la croissance de la structure de couche active comprend la croissance d'une couche de GaN dopée n et, au-dessus de la couche de GaN dopée n, la structure à puits quantiques multiples et dans lequel la fabrication d'une structure de micro LED à partir de la plaquette épitaxiale de de GaN sur Si comprend l'amincissement de la plaquette épitaxiale de GaN sur Si en partant de l'arrière du substrat jusqu'à la couche de GaN dopée n sous la structure à puits quantiques multiples
